# EUROPÄISCHE PATENTSCHRIFT

(11) **EP 1 977 457 B1**
(45) Veröffentlichungstag und Bekanntmachung des Hinweises auf die Patenterteilung: **09.05.2018**
(21) Anmeldenummer: 06828719.2
(22) Anmeldetag: 20.12.2006
(51) Int. Cl.: H01L 33/20, H01L 33/32, H01L 33/40, H01L 33/42

(54) **OPTOELEKTRONISCHER HALBLEITERCHIP**
OPTOELECTRONIC SEMICONDUCTOR CHIP
PUCE A SEMI-CONDUCTEURS OPTO-ELECTRONIQUE

(30) Priorität: 27.01.2006 DE 102006004172; 04.04.2006 DE 102006015788
(43) Veröffentlichungstag der Anmeldung: 08.10.2008
(73) Patentinhaber: OSRAM Opto Semiconductors GmbH, 93055 Regensburg (DE)
(72) Erfinder: FEHRER, Michael, 93077 Bad Abbach (DE); STRAUSS, Uwe, 93077 Bad Abbach (DE)
(74) Vertreter: Epping - Hermann - Fischer
(86) Internationale Anmeldenummer: PCT/DE2006/002293
(87) Internationale Veröffentlichungsnummer: WO 2007/085218

(56) Entgegenhaltungen:
- WO-A2-03/043092
- DE-U1- 20 022 541
- US-A1- 2002 123 164
- US-A1- 2004 266 043
- US-A1- 2005 173 724
- Gary Y. Robinson: "Methods of Forming Ohmic Contacts" In: "Physics and Chemistry of Iii-V Compound Semiconductor Interfaces", 1 January 1985 (1985-01-01), Kluwer Academic Publishers, US, XP055362016, ISBN: 978-0-306-41769-6 pages 130-137,
- J. D. Guo ET AL: "A bilayer Ti/Ag ohmic contact for highly doped n -type GaN films", Applied Physics Letters, vol. 68, no. 2, 8 January 1996 (1996-01-08), pages 235-237, XP55361885, US ISSN: 0003-6951, DOI: 10.1063/1.116471

## Beschreibung

Die vorliegende Erfindung betrifft einen optoelektronischen Halbleiterchip, insbesondere einen strahlungsemittierenden Halbleiterchip.

Eine Aufgabe der vorliegenden Erfindung ist es, einen verbesserten optoelektronischen Halbleiterchip, insbesondere einen Halbleiterchip mit erhöhter Auskoppeleffizienz anzugeben.

Diese Aufgabe wird durch einen Halbleiterchip mit den Merkmalen des unabhängigen Patentanspruchs gelöst. Vorteilhafte Ausgestaltungen und Weiterbildungen sind Gegenstand der abhängigen Patentansprüche.

Gemäß zumindest einer Ausführungsform umfasst der optoelektronische Halbleiterchip einen Anschluss, eine Haftvermittlungsschicht, eine Reflektorschicht und eine Halbleiterschichtenfolge mit einem zur Strahlungserzeugung geeigneten aktiven Bereich, wobei die Halbleiterschichtenfolge vorzugsweise eine laterale Haupterstreckungsrichtung aufweist. Zwischen dem aktiven Bereich und dem Anschluss ist die Reflektorschicht angeordnet, und die Haftvermittlungsschicht ist zwischen der Reflektorschicht und der Kontaktschicht angeordnet. Die Halbleiterschichtenfolge ist bevorzugt auf einem Substrat angeordnet. Das Substrat kann das Aufwachssubstrat, auf dem die Halbleiterschichtenfolge, insbesondere epitaktisch, gewachsen ist, umfassen, aus diesem gebildet sein oder, etwa über Strukturierung oder anderweitige Bearbeitung, aus diesem ausgebildet sein. Das Substrat kann insbesondere abgedünnt sein. Die Bauhöhe des Chips wird mit Abdünnung des Substrats vorteilhaft verringert. Vorzugsweise stabilisiert das Substrat, insbesondere auch das bearbeitete, zum Beispiel abgedünnte Substrat die Halbleiterschichtenfolge mechanisch.

Gemäß zumindest einer Ausführungsform enthält oder basiert die Halbleiterschichtenfolge, insbesondere der aktive Bereich auf einem Nitrid-Verbindungshalbleitermaterial.

"Auf Nitrid-Verbindungshalbleitern basierend" bedeutet im vorliegenden Zusammenhang, dass die Halbleiterschichtenfolge oder zumindest eine Schicht davon ein Nitrid-III/V-Verbindungshalbleitermaterial, vorzugsweise AlₙGamIn₁₋ₙ₋ₘN umfasst, wobei 0 ≤ n ≤1, 0 ≤ mm ≤1 und n+m ≤ 1. Hierbei ist bevorzugt n≠0 und/oder m≠0. Weiterhin ist bevorzugt n≠1 und/oder m≠1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die charakteristischen physikalischen Eigenschaften des AlₙGaₘIn₁₋ₙ₋ₘN-Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

Nitrid-Verbindungshalbleitermaterialien eignen sich besonders zur Erzeugung von Strahlung im ultravioletten und auch dem sichtbaren Spektralbereich, insbesondere vom blauen bis in den grünen Spektralbereich.

Als (Aufwachs-)Substrat ist für eine Halbleiterschichtenfolge auf Nitrid-Verbindungshalbleiter-Basis ein Siliziumcarbid-(SiC), Galliumnitrid- (GaN), Aluminiumnitrid- (AlN) oder Saphir-haltiges Substrat besonders geeignet.
Gemäß zumindest einer Ausführungsform umfasst der aktive Bereich eine Ein- oder Mehrfach-Quantentopfstruktur. Die Bezeichnung Quantentopfstruktur umfasst im Rahmen der Anmeldung jegliche Struktur, bei der Ladungsträger durch Einschluss ("confinement") eine Quantisierung ihrer Energiezustände erfahren können oder vorzugsweise erfahren. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte sowie jede Kombination dieser Strukturen. Eine Quantentopfstruktur ist zur Erzeugung von Strahlung mit hoher interner Quanteneffizienz besonders geeignet.

Gemäß der Erfindung ist das Substrat strahlungsdurchlässig für die in dem aktiven Bereich erzeugte Strahlung. Das Substrat kann insbesondere aus einem für die erzeugte Strahlung durchlässigen Material gebildet sein. Gegenüber einem maßgeblich absorbierenden Substrat wird hierdurch die Strahlungsauskopplung aus dem Halbleiterchip durch das Substrat erleichtert. Der Halbleiterchip kann somit vereinfacht als Volumenstrahler ausgebildet sein. Bei einem Volumenstrahler wird im Gegensatz zu einem Oberflächenstrahler, das heißt einem Halbleiterchip, bei dem Strahlung überwiegend, zum Beispiel 90 % oder mehr der gesamten aus dem Chip ausgekoppelten Strahlungsleistung, über eine, insbesondere eine einzelne Oberfläche der Halbleiterschichtenfolge ausgekoppelt wird, auch über das Substrat ein maßgeblicher Strahlungsanteil aus dem Chip ausgekoppelt. Die Oberflächenleuchtdichte an den Auskoppelflächen des Halbleiterchips ist bei einem Volumenstrahler gegenüber einem Oberflächenstrahler verringert, wobei aufgrund der verringerten Oberflächenleuchtdichte an den Auskoppelflächen die Gefahr von durch hohe Leuchtdichten verursachten Verfärbungen oder Trübungen, zum Beispiel der Bräunung, einer strahlungsdurchlässigen Umhüllung, in die der Halbleiterchip eingebettet werden kann, verringert ist.
Von besonderem Vorteil ist dies bei einem Halbleiterchip, der zur Erzeugung hochenergetischer, vergleichsweise kurzwelliger, zum Beispiel blauer oder ultravioletter Strahlung ausgebildet ist. Dies ist beispielsweise oftmals bei einem Halbleiterchip auf Nitrid-Verbindungshalbleiter-Basis der Fall. Eine Umhüllung, die ein Reaktionsharz, zum Beispiel ein Epoxid- oder Acrylharz, enthält, trübt unter Bestrahlung mit hochenergetischer Strahlung besonders schnell, sodass ein Volumenstrahler hier besondere Vorteile bietet. Die Gefahr einer strahlungsbedingten Verfärbung oder einer Trübung der Umhüllung kann durch eine ein Silikon oder ein Silikonharz enthaltende Umhüllung, die sich durch erhöhte Strahlungsstabilität auszeichnet, weitergehend verringert werden. Gemäß der Erfindung ist der Halbleiterchip frei von einem, zum Beispiel metallisch oder als Braggspiegel ausgeführten, Reflektor zwischen der Halbleiterschichtenfolge und dem Substrat, sodass der Strahlungseintritt aus der Halbleiterschichtenfolge in das Substrat und somit die Ausbildung eines Volumenstrahlers erleichtert wird.

Gemäß der Erfindung ist eine Oberfläche des Substrats, insbesondere eine Seitenfläche und/oder eine der Halbleiterschichtenfolge zugewandte Oberfläche des Substrats, als Strahlungsauskoppelfläche des Halbleiterchips ausgebildet. Ist die der Halbleiterschichtenfolge zugewandte Oberfläche des Substrats als Strahlungsauskoppelfläche ausgebildet, so bildet bevorzugt ein Teilbereich dieser Oberfläche, der nicht von der Halbleiterschichtenfolge bedeckt ist, einen Auskoppelbereich dieser Oberfläche.
Gemäß zumindest einer Ausführungsform ist der Brechungsindex des Substrats größer oder gleich dem Brechungsindex des aktiven Bereichs und/oder es ist der Brechungsindex des Substrats größer oder gleich dem Brechungsindex einer die Halbleiterschichtenfolge auf der dem Substrat zugewandten Seite abschließenden, insbesondere die Halbleiterschichtenfolge begrenzenden Halbleiterschicht der Schichtenfolge. Der Strahlungsübertritt aus der Halbleiterschichtenfolge in das Substrat wird hierdurch aufgrund der verminderten Reflexion oder der entfallenden Totalreflexion an der Grenzfläche zum Substrat erleichtert. Für den Brechungsindex des aktiven Bereichs kann gegebenenfalls ein Mittelwert, zum Beispiel das arithmetische oder das geometrische Mittel der Brechungsindices der den aktiven Bereich bildenden Schichten herangezogen werden.
Für Nitrid-Verbindungshalbleitermaterialien ist ein SiC- oder GaN-haltiges Substrat hinsichtlich obiger Relation für die Brechungsindices besonders geeignet.

Gemäß der Erfindung weist der Halbleiterchip eine Seitenfläche auf, wobei die Seitenfläche einen bezüglich der lateralen Haupterstreckungsrichtung der Halbleiterschichtenfolge angeschrägten Seitenflächenbereich und/oder eine Ausnehmung aufweist. Die Seitenfläche ist bevorzugt durch eine Seitenfläche des Substrats gebildet. Weiterhin begrenzt die Seitenfläche den Halbleiterchip vorzugsweise lateral. Die Ausnehmung erstreckt sich bevorzugt von der der Halbleiterschichtenfolge abgewandten Oberfläche des Substrats, insbesondere von dieser Oberfläche ausgehend, in Richtung der Halbleiterschichtenfolge.

Mittels der Ausnehmung beziehungsweise der angeschrägten Seitenfläche kann der Anteil an in der Halbleiterschichtenfolge erzeugter und unmittelbar, das heißt ohne (Mehrfach)Reflexion im Substrat, aus dem Substrat über die Ausnehmung beziehungsweise die Seitenfläche ausgekoppelter Strahlung erhöht werden. Die durch das Substrat ausgekoppelte Strahlungsleistung und in der Folge die Auskoppeleffizienz des optoelektronischen Halbleiterchips werden so vorteilhaft erhöht. Als besonders geeignet hat es sich hierbei herausgestellt, dass der angeschrägte Seitenflächenbereich mit der Halbleiterschichtenfolge einen spitzen Winkel einschließt.

Das Substrat kann sich mit wachsendem Abstand von der Halbleiterschichtenfolge, insbesondere im angeschrägten Bereich der angeschrägten Seitenfläche verjüngen. Hierzu ist die Seitenfläche zweckmäßigerweise geeignet angeschrägt. Die Seitenfläche kann in dem Bereich, in dem sich das Substrat verjüngt und/oder im Bereich der Ausnehmung, eine treppenartige Struktur aufweisen oder gekrümmt sein.

Die Anschrägung bzw. die Ausnehmung kann insbesondere mittels eines geeigneten Trennwerkzeugs, das vorzugsweise entsprechend der Ausnehmung bzw. der Anschrägung geformt ist, z.B. einem Sägeblatt beim Vereinzeln des Chips aus dem Waferverbund erzeugt werden. Das Substrat kann also entsprechend gesägt sein.

Die Ausnehmung kann mittels des schräg zur Halbleiterschichtenfolge verlaufenden Seitenflächenbereichs und vorzugsweise eines weiteren Seitenflächenbereichs dieser Seitenfläche gebildet sein. Bevorzugt ist der weitere Seitenflächenbereich unter einem von dem des ersteren Seitenflächenbereichs verschiedenen Winkel zur Haupterstreckungsrichtung angeschrägt oder verläuft im Wesentlichen senkrecht zur Halbleiterschichtenfolge und insbesondere der Haupterstreckungsrichtung. Der weitere Seitenflächenbereich ist dem ersteren Seitenflächenbereich von der Halbleiterschichtenfolge aus gesehen bevorzugt nachgeordnet.

Gemäß zumindest einer Ausführungsform weist das Substrat auf der der Halbleiterschichtenfolge abgewandten Seite einen kleineren Querschnitt auf als auf der der Halbleiterschichtenfolge zugewandten Seite.

Bevorzugt weist das Substrat zwei Seitenflächen auf, wobei zwei Seitenflächenbereiche dieser Seitenflächen von der der Halbleiterschichtenfolge abgewandte Oberfläche des Substrats ausgehend in Richtung der Halbleiterschichtenfolge im Wesentlichen parallel, zum Beispiel unter Einschluss eines Winkels kleiner oder gleich 5°, insbesondere kleiner oder gleich 2°, oder parallel zueinander verlaufen. Ein derartiger Halbleiterchip kann an den im Wesentlichen parallel verlaufenden Seitenflächen mittels eines Montagewerkzeugs, zum Beispiel eines zur Montage des Chips auf einem externen Anschlussleiter, etwa einem externen Anschlussleiter für ein bedrahtetes Radial-Bauelement oder ein oberflächenmontierbares Bauelement, vereinfacht gefasst werden.
Weiterhin kann das Substrat seitens der Halbleiterschichtenfolge einen im Wesentlichen senkrecht, zum Beispiel mit einer Abweichung von 5° oder weniger, insbesondere 2° oder weniger, vom rechten Winkel oder senkrecht zur lateralen Haupterstreckungsrichtung der Halbleiterschichtenfolge verlaufenden Seitenflächenbereich aufweisen. Dieser Seitenflächenbereich geht vorzugsweise in die Ausnehmung und/oder den angeschrägten Seitenflächenbereich über. Der angeschrägte Seitenflächenbereich beziehungsweise die Ausnehmung ist dem senkrecht oder im Wesentlichen senkrecht verlaufenden Seitenflächenbereich von der Halbleiterschichtenfolge aus gesehen mit anderen Worten vorzugsweise nachgeordnet.

Gemäß der Erfindung weist der Halbleiterchip eine strahlungsdurchlässige und elektrisch leitfähige Kontaktschicht auf. Die Strahlungsauskopplung aus dem Halbleiterchip kann aufgrund der Strahlungsdurchlässigkeit dieser Kontaktschicht für im aktiven Bereich erzeugte Strahlung erhöht werden. Die Kontaktschicht ist mit dem aktiven Bereich der Halbleiterschichtenfolge zweckmäßigerweise elektrisch leitend verbunden. Bevorzugt grenzt die Kontaktschicht, insbesondere vollflächig und/oder direkt, an den Halbleiterchip an.
Gemäß zumindest einer Ausführungsform enthält die Kontaktschicht ein strahlungsdurchlässiges und elektrisch leitfähiges Oxid (TCO: Transparent Conducting Oxide), insbesondere ein Metalloxid, beispielsweise ein Indiumzinnoxid, wie InO, ein Zinnoxid, wie SnO₂ ein Indiumzinnoxid (ITO: Indium Tin Oxide), wie InSnO, oder ein Zinkoxid, wie ZnO. Strahlungsdurchlässige elektrisch leitfähige Oxide zeichnen sich durch hohe Strahlungsdurchlässigkeit bei gleichzeitig hoher Leitfähigkeit in lateraler Richtung aus. Über den mit der Kontaktschicht elektrisch leitend verbundenen, zum Beispiel metallischen oder legierungsbasierten, Anschluss kann vergleichsweise kleinflächig Strom in die Kontaktschicht initiiert werden. Dieser kann in der Kontaktschicht widerstandsarm lateral homogen verteilt und großflächig in die Halbleiterschichtenfolge injiziert werden.

Eine TCO-haltige Kontaktschicht kann eine Leitfähigkeit in lateraler Richtung von größer oder gleich 40 Ωsq, bevorzugt größer oder gleich 100 Ωsq, besonders bevorzugt größer oder gleich 200 Ωsq aufweisen.

Zur Erhöhung der Leitfähigkeit in lateraler Richtung kann die Kontaktschicht dotiert sein. Für ein Zinkoxid eignet sich als Dotierstoff zum Beispiel Al, für ein Zinnoxid beispielsweise Sb.

Für eine hohe Leitfähigkeit in lateraler Richtung weist eine TCO-haltige Kontaktschicht, insbesondere eine Kontaktschicht, die ein Indiumzinnoxid enthält, bevorzugt eine unterstöchiometrische Zusammensetzung, z.B. in der Form von Sauerstoff-Fehlstellen auf.

Eine ITO-haltige Kontaktschicht kann weiterhin Indium-Fehlstellen aufweisen. Die Indium-Fehlstellen können wenigstens teilweise mit Zinn besetzt sein. Eine derartige Ausbildung ist für hohe Leitfähigkeiten in lateraler Richtung besonders geeignet.

Bevorzugt ist der Indiumoxidanteil in einer ITO-haltigen Kontaktschicht größer als der Zinnoxid-Anteil.

Hierdurch kann insgesamt vereinfacht ein n-Leitungstyp der Kontaktschicht erzielt werden.

Ein ITO oder ein Zinkoxid eignen sich besonders zur elektrischen Kontaktbildung zu p-leitenden Halbleitermaterialien. Ein Zinnoxid eignet sich besonders zur Kontaktbildung zu n-leitenden Halbleitermaterialien. Mittels strahlungsdurchlässiger elektrisch leitfähiger Oxide kann eine strahlungsdurchlässige Kontaktschicht als Stromaufweitungsschicht hoher Querleitfähigkeit ausgebildet werden, die einen guten, vorzugsweise barrierefreien, elektrischen Kontakt, insbesondere einen ohmschen Kontakt, das heißt einen Kontakt mit im Wesentlichen linearer Strom-Spannungs-Charakteristik, zwischen der Kontaktschicht und der Halbleiterschichtenfolge erleichtert.

Zur homogenen Stromeinprägung in die Halbleiterschichtenfolge ist die Kontaktschicht zweckmäßigerweise als durchgehende, insbesondere ununterbrochene Schicht ausgeführt. Weiterhin überdeckt oder bedeckt die Kontaktschicht die Halbleiterschichtenfolge, gegebenenfalls bis auf eine kleinflächige randseitige Aussparung, mit Vorzug vollständig.

Vorzugsweise ist die Kontaktschicht auf der dem Substrat abgewandten Oberfläche der Halbleiterschichtenfolge angeordnet und/oder grenzt die Kontaktschicht an eine p-leitende Halbleiterschicht der Halbleiterschichtenfolge an. In einem Halbleiterchip, der nicht Teil der Erfindung ist, kann zwischen der Kontaktschicht und dem aktiven Bereich ein Tunnelkontakt ausgebildet sein. Der Tunnelkontakt kann insbesondere zwischen der Kontaktschicht und dem aktiven Bereich angeordnet sein. Der Tunnelkontakt weist bevorzugt eine oder eine Mehrzahl von monolithisch in die Halbleiterschichtenfolge integrierten, insbesondere dotierten, Tunnelkontaktschichten auf.
Eine Tunnelkontaktschicht des Tunnelkontakts grenzt vorzugsweise, insbesondere direkt, an die Kontaktschicht an. Mittels einer Tunnelkontaktschicht zwischen dem aktiven Bereich und der Kontaktschicht kann der Spannungsabfall ("Verlustspannung") am Übergang Kontaktschicht/Halbleiterschichtenfolge gegenüber einem Halbleiterchip, bei dem auf eine Tunnelkontaktschicht verzichtet ist, im Betrieb des Halbleiterchips verringert werden. Die Tunnelkontaktschicht weist bevorzugt einen Leitungstyp auf, der von einer an den Tunnelkontakt angrenzenden Halbleiterschicht der Halbleiterschichtenfolge verschieden ist. Ist diese Halbleiterschicht beispielsweise p-leitend ausgebildet, so ist die Tunnelkontaktschicht n-leitend ausgeführt. Die Tunnelkontaktschicht grenzt vorzugsweise unmittelbar an die Kontaktschicht an. Bei einer vorgegebenen Betriebsspannung des Halbleiterchips kann aufgrund des mittels des Tunnelkontakts reduzierten Spannungsverlustes die im aktiven Bereich in Strahlungsleistung umgewandelte elektrische Leistung erhöht werden.
Die Tunnelkontaktschicht weist bevorzugt eine Dicke von 30 nm oder weniger, besonders bevorzugt 20 nm oder weniger auf. Weiterhin ist die Dicke der Tunnelkontaktschicht bevorzugt größer oder gleich 3 nm. Derartige Dicken haben sich als besonders vorteilhaft erwiesen.

Der Tunnelkontakt umfasst bevorzugt eine weitere Tunnelkontaktschicht. Mittels der weiteren Tunnelkontaktschicht kann der Spannungsverlust im Betrieb des Halbleiterchips weitergehend verringert werden.

Die weitere Tunnelkontaktschicht ist hinsichtlich der Dicke bevorzugt entsprechend der für die obige Tunnelkontaktschicht angegebenen Dickenbereiche ausgebildet.

Umfasst der Tunnelkontakt eine Mehrzahl von Tunnelkontaktschichten, so weisen zwei monolithisch in die Halbleiterschichtenfolge integrierte Tunnelkontaktschichten bevorzugt unterschiedliche Leitungstypen auf.

Die weitere Tunnelkontaktschicht weist bevorzugt den gleichen Leitungstyp auf wie die seitens des aktiven Bereichs an den Tunnelkontakt, insbesondere an die weitere Tunnelkontaktschicht angrenzende Halbleiterschicht der Halbleiterschichtenfolge. Beispielsweise ist die weitere Tunnelkontaktschicht hierzu p-leitend ausgeführt.

Eine dotierte Tunnelkontaktschicht ist vorzugsweise hoch dotiert ausgeführt (p⁺ bzw. n⁺). Eine Dotierstoffkonzentration in der Tunnelkontaktschicht kann hierzu 1 * 10¹⁹ cm⁻³ oder mehr, bevorzugt 1 * 10²⁰ cm⁻³ oder mehr betragen.

Der Tunnelkontakt ist weiterhin bevorzugt mit zwei monolithisch integrierten Tunnelkontaktschichten unterschiedlichen Leitungstyps als Tunneldiode ausgeführt.

Besonders zweckmäßig ist ein Tunnelkontakt dann, wenn die Potentialbarriere zwischen der Kontaktschicht und der Halbleiterschichtenfolge ohne einen zwischengeschalteten Tunnelübergang, wie etwa im Falle eines maßgeblich sperrenden pn-Übergangs zwischen der Kontaktschicht und der Halbleiterschichtenfolge, vergleichsweise hoch ist.
Zwischen einem n-leitenden TCO, etwa n-leitendem ITO, für die Kontaktschicht und einer unmittelbar an diese Kontaktschicht angrenzenden p-leitenden Halbleiterschicht, etwa einer Schicht auf Nitrid-Verbindungshalbleiterbasis, der Halbleiterschichtenfolge kann sich ein derartiger sperrender pn-Übergang, der den Ladungsträgereintritt in die Halbleiterschichtenfolge maßgeblich behindert bzw. maßgeblich zur Verlustspannung beiträgt, ausbilden.
Mittels des Tunnelkontakts kann vereinfacht ein vergleichsweise spannungsverlustarmer elektrischer Kontakt zwischen der Kontaktschicht und der Halbleiterschichtenfolge, insbesondere ein Kontakt mit einer ohmschen Strom-Spannungs-Charakteristik hergestellt werden. In einem Halbleiterchip, der nicht Teil der Erfindung ist, kann zwischen der Tunnelkontaktschicht und dem aktiven Bereich eine Zwischenschicht angeordnet sein. Die Zwischenschicht ist bevorzugt undotiert ausgeführt. Die Zwischenschicht kann als Barriereschicht ausgebildet sein, die eine Diffusion eines Dotierstoffes aus der Tunnelkontaktschicht durch die Barriereschicht hindurch oder durch die Barriereschicht in die Tunnelkontaktschicht hinein behindert oder vollständig blockiert. Beispielsweise kann die Zwischenschicht als Barriereschicht für einen Akzeptor, z.B. Mg, dienen, mit dem eine auf der der Tunnelkontaktschicht abgewandten Seite der Halbleiterschichtenfolge, insbesondere auf der der Tunnelkontaktschicht abgewandten Seite der Zwischenschicht angeordnete Halbleiterschicht dotiert ist.

Eine Diffusion von Dotierstoffen in die Tunnelkontaktschicht, insbesondere aus einem Bereich der Halbleiterschichtenfolge mit einem vom Leitungstyp der Tunnelkontaktschicht verschiedenen Leitungstyp kann die Stromtragfähigkeit der Tunnelkontaktschicht und hierüber die des Chips verringern und in der Folge einen Ausfall des Chips im regulären Betrieb (mit)verursachen. Die Zwischenschicht ist bevorzugt im Tunnelkontakt integriert und besonders bevorzugt zwischen zwei Tunnelkontaktschichten mit unterschiedlichen Leitungstypen angeordnet. Die Zwischenschicht ist bevorzugt als Barriereschicht ausgebildet, die das Eindringen eines entsprechenden Dotierstoffs aus der weiter oben genannten weiteren Tunnelkontaktschicht in die Tunnelkontaktschicht behindert.

Weiterhin weist die Zwischenschicht bevorzugt eine Dicke von 10 nm oder weniger auf.

Eine Tunnelkontaktschicht des Tunnelkontakts kann gegebenenfalls auch als Mehrschichtstruktur, z.B. als Übergitterstruktur, ausgeführt sein.

Alternativ zum Vorsehen eines Tunnelkontakts mit zwei Tunnelkontaktschichten unterschiedlichen Leitungstyps kann gegebenenfalls auch ohne einen Tunnelkontakt ein guter elektrischer Kontakt, vorzugsweise ein ohmscher Kontakt, zwischen der Kontaktschicht und dem Halbleiterkörper ausgebildet werden. Gemäß der Erfindung ist hierzu eine an die strahlungsdurchlässige Kontaktschicht angrenzende Anschlussschicht im Halbleiterkörper angeordnet. Diese Anschlussschicht ist zweckmäßigerweise für die Kontaktbildung zu der strahlungsdurchlässigen Kontaktschicht optimiert. Die Anschlussschicht ist dotiert ausgeführt. Für eine Kontaktbildung zur Kontaktschicht hat es sich als besonders vorteilhaft herausgestellt, dass die Anschlussschicht auf der der Kontaktschicht zugewandten Seite und insbesondere in dem Kontaktbereich, in dem die Anschlussschicht an die Kontaktschicht angrenzt, eine andere Dotierstoffkonzentration aufweist, als in einem Bereich der Anschlussschicht, der weiter von der Kontaktschicht entfernt und insbesondere näher an dem aktiven Bereich angeordnet ist. Gemäß der Erfindung ist die Dotierstoffkonzentration in der Anschlussschicht seitens der Kontaktschicht größer als seitens des aktiven Bereichs.
Die unterschiedlichen Dotierstoffkonzentrationen in der Anschlussschicht können insbesondere deutlich voneinander abweichen. Eine Abweichung der beiden Dotierstoffkonzentrationen voneinander beträgt bevorzugt 30 % oder mehr, besonders bevorzugt 40 % oder mehr. Die Dotierstoffkonzentration in der Anschlussschicht kann also in dem Bereich nahe der Kontaktschicht, insbesondere im unmittelbaren Kontaktbereich, das 1,3-fache oder mehr, bevorzugt das 1,4-fache oder mehr der Dotierstoffkonzentration in einem von der Kontaktschicht weiter entfernten und näher am aktiven Bereich angeordneten Bereich der Anschlussschicht betragen.

Die Anschlussschicht enthält vorzugsweise ein Nitrid-Verbindungshalbleitermaterial. Die Anschlussschicht kann beispielsweise GaN enthalten oder daraus bestehen. Weiterhin ist die Anschlussschicht vorzugsweise p-leitend dotiert ausgeführt. Als besonders geeignet hat es sich herausgestellt, Mg als Akzeptor für die p-Dotierung einzusetzen.

Als für einen geringen Kontaktwiderstand zwischen der Kontaktschicht und der Anschlussschicht besonders geeignet hat sich eine Dotierstoffkonzentration in der Anschlussschicht von 3 * 10¹⁹ cm⁻³ oder mehr, z.B. von zwischen einschließlich 3 * 10¹⁹ cm⁻³ und einschließlich 5 * 10²⁰ cm⁻³, erwiesen. In einem von der Kontaktschicht entfernten Bereich der Anschlussschicht kann diese eine Dotierstoffkonzentration von 2 * 10¹⁹ cm⁻³ oder weniger aufweisen. Bei einer im Inneren der Anschlussschicht gegenüber dem Grenzbereich zur Kontaktschicht verringerten Dotierstoffkonzentration kann die Konzentration an freien Ladungsträger in der Anschlussschicht und somit die Leitfähigkeit in Richtung des aktiven Bereichs höher sein als im Falle einer über den Schichtverlauf, insbesondere senkrecht zur lateralen Haupterstreckungsrichtung, gleichbleibend hohen Dotierstoffkonzentration. Eine hohe Dotierstoffkonzentration im Kontaktbereich zur Kontaktschicht erleichtert jedoch das Ausbilden eines niederohmigen, und damit verlustarmen elektrischen Kontaktes der Kontaktschicht zum aktiven Bereich. Insbesondere kann so vereinfacht ein ohmscher elektrischer Kontakt zum Halbleiterkörper erzielt werden.

Eine Dicke der Anschlussschicht kann 30 nm oder mehr, besonders bevorzugt 50 nm oder mehr oder sogar 100nm oder mehr betragen.
Der Halbleiterchip weist den elektrischen Anschluss auf, der mit der strahlungsdurchlässigen und elektrisch leitfähigen Kontaktschicht elektrisch leitend verbunden ist.
Der Anschluss kann als Bondpad, das heißt als zur Kontaktierung mit einem Bonddraht vorgesehen, ausgebildet sein. Vorzugsweise enthält der Anschluss ein Metall, zum Beispiel Au. Der Anschluss kann insbesondere metallisch oder auf Legierungsbasis ausgeführt sein. Der Anschluss ist mit dem aktiven Bereich zweckmäßigerweise elektrisch leitend verbunden.
Bevorzugt ist der elektrische Anschluss des Halbleiterchips auf der dem Substrat abgewandten Seite der Halbleiterschichtenfolge und/oder auf der der Halbleiterschichtenfolge abgewandten Seite der Kontaktschicht angeordnet.

Gemäß der Erfindung ist zwischen dem elektrischen Anschluss und der Halbleiterschichtenfolge, insbesondere zwischen der Kontaktschicht und dem Anschluss, die Reflektorschicht angeordnet. Die Reflektorschicht enthält vorzugsweise ein Metall, zum Beispiel Al oder Ag. Diese Metalle zeichnen sich durch besonders hohe Reflektivitäten für kurzwellige Strahlung aus. Die Reflektorschicht ist vorzugsweise metallisch oder auf Legierungsbasis ausgebildet. Mittels der Reflektorschicht kann die Absorption von Strahlung im Anschluss vermindert werden. Die Strahlung kann vielmehr mittels der Reflektorschicht in die Halbleiterschichtenfolge zurück reflektiert und aus dem Halbleiterchip ausgekoppelt werden, anstatt eventuell im Anschluss absorbiert zu werden. Hierdurch kann die Auskoppeleffizienz des Halbleiterchips, das heißt das Verhältnis der im Halbleiterchip erzeugten Strahlungsleistung zu der aus dem Halbleiterchip ausgekoppelten Strahlungsleistung erhöht werden.

Zwischen der Reflektorschicht und der Kontaktschicht ist die Haftvermittlungsschicht angeordnet. Insbesondere ist zwischen dem Anschluss und der Kontaktschicht die Haftvermittlungsschicht angeordnet. Die Haftvermittlungsschicht erhöht bevorzugt die Haftung des Anschlusses und/oder der Reflektorschicht am Halbleiterchip, insbesondere die Haftung der Reflektorschicht an der Kontaktschicht.

Die Haftvermittlungsschicht enthält bevorzugt ein Metall, beispielsweise Pd oder Pt und ist besonders bevorzugt metallisch oder auf Legierungsbasis ausgeführt.

Die Haftvermittlungsschicht ist mit Vorzug, um die in der Haftvermittlungsschicht absorbierte Strahlungsleistung vorteilhaft gering zu halten, transparent oder semitransparent ausgeführt. Bevorzugt ist eine Dicke der Haftvermittlungsschicht kleiner als 3 nm, besonders bevorzugt kleiner als 1 nm. Die Haftvermittlungsschicht kann insbesondere inselartig, vorzugsweise mit einer Mehrzahl von Haftvermittlungsinseln ausgeführt sein. Eine durchgehende Schicht ist für die Haftvermittlung nicht erforderlich.

Gemäß zumindest einer Ausführungsform ist der Halbleiterchip als Lumineszenzdiode, etwa als Lichtemissionsdiode oder als Laserdiode ausgeführt, wobei die Ausbildung eines Volumenstrahlers selbstverständlich für eine Lichtemissionsdiode besonders zweckmäßig ist.

Gemäß zumindest einer Ausführungsform umfasst der Halbleiterchip einen elektrischen Gegenanschluss, der bevorzugt mit dem aktiven Bereich elektrisch leitend verbunden ist. Mittels des elektrischen Anschlusses und des elektrischen Gegenanschlusses kann der Halbleiterchip elektrisch kontaktiert werden. Der Gegenanschluss enthält bevorzugt ein Metall und ist besonders bevorzugt metallisch oder auf Legierungsbasis ausgeführt.

Weiterhin sind der Anschluss und der Gegenanschluss bevorzugt auf gegenüberliegenden Seiten der Halbleiterschichtenfolge angeordnet. Der Halbleiterchip kann demnach mit einer in vertikaler Richtung leitfähigen Struktur zwischen dem Anschluss und dem Gegenanschluss ausgeführt sein. Dies erleichtert eine einfache und zuverlässige Montage des Halbleiterchips auf einem externen Anschlussleiter.

Gegenüber einer Anordnung beider Anschlüsse auf der gleichen Seite der Halbleiterschichtenfolge kann so bei der Herstellung der Halbleiterchips ein kleineres Chipraster gewählt werden, wodurch aus einer Halbleiterschichtstruktur eines Halbleiterwafers eine höhere Anzahl an Halbleiterschichtenfolgen für einzelne Halbleiterchips gewonnen werden kann als bei einem Halbleiterchip, bei dem der Anschluss und der Gegenanschluss auf der gleichen Seite der Halbleiterschichtenfolge angeordnet sind. Letztere Anordnung der Anschlüsse erfordert aufgrund der Anschlussanordnung eine großflächigere Halbleiterschichtenfolge für den Einzelchip. Über eine Anordnung der Anschlüsse auf verschiedenen Seiten der Halbleiterschichtenfolge kann die Fläche der Halbleiterschichtenfolge demgegenüber reduziert werden. Die Ausbeute an Halbleiterchips aus einem Halbleiterwafer wird in der Folge erhöht.

Bevorzugt ist der elektrische Gegenanschluss des Halbleiterchips auf der der Halbleiterschichtenfolge abgewandten Oberfläche des Substrats angeordnet. Zur elektrisch leitenden Verbindung des Gegenanschlusses mit dem aktiven Bereich ist das Substrat zweckmäßigerweise elektrisch leitfähig ausgeführt. Gegebenenfalls kann das Substrat hierzu geeignet dotiert sein, etwa in der Form eines stickstoffdotierten SiC-Substrats.

Ein derartiger Gegenanschluss erleichtert die elektrisch leitende Verbindung, zum Beispiel über Verklebung oder Verlötung, des Chips mit einem externen Anschlussleiter, zum Beispiel für ein optoelektronisches Bauteil, etwa ein Radial-Bauteil oder ein oberflächenmontierbares Bauteil. Ein oberflächenmontierbares Bauteil kann auf besonders einfache und Platz sparende Weise auf einem externen Bauteilträger, etwa einer Leiterplatte, montiert werden. Mittels einer Anordnung des Gegenanschlusses und des Anschlusses des Chips auf verschiedenen Seiten der Halbleiterschichtenfolge kann auf eine gegebenenfalls zusätzliche Drahtbondung verzichtet werden, da einer der Anschlüsse, vorzugsweise der Gegenanschluss, ohne eine Drahtverbindung sondern vielmehr mittels einer Verbindungsschicht, etwa einer Lot- oder Klebeschicht, mit einem externen Anschlussleiter elektrisch leitend verbunden und insbesondere befestigt werden kann.

Gemäß zumindest einer Ausführungsform ist das Substrat auf der der Halbleiterschichtenfolge abgewandten Seite vollständig oder teilweise mit einer Spiegelschicht versehen. Die Spiegelschicht enthält bevorzugt ein Metall, z. B. Al oder Ag, und ist besonders bevorzugt metallisch oder auf Legierungsbasis ausgeführt. Die Spiegelschicht kann insbesondere auf das Substrat aufgebracht, beispielsweise aufgesputtert oder aufgedampft sein. Mittels der Spiegelschicht kann Strahlung in das Substrat zurückreflektiert werden. Absorptionsverluste in einem externen Anschlussleiter werden so vorteilhaft verringert. Ferner kann die durch die der Halbleiterschichtenfolge zugewandte Oberfläche des Substrats tretende und insbesondere die über diese Oberfläche ausgekoppelte Strahlungsleistung erhöht werden. Die Spiegelschicht kann zwischen dem Gegenanschluss und dem Substrat oder lateral neben dem Gegenanschluss angeordnet sein.

Bevorzugt ist eine Seitenfläche des Substrats teilweise oder vollständig verspiegelt. Beispielsweise kann die Ausnehmung und/oder der angeschrägte Seitenflächenbereich teilweise oder vollständig verspiegelt sein.

Die auf der der Halbleiterschichtenfolge abgewandten Seite des Substrats vorgesehene Spiegelschicht kann sich, insbesondere als durchgehende Schicht entlang des angeschrägten Seitenflächenbereichs der Seitenfläche des Substrats und/oder entlang der Ausnehmung erstrecken.

Gemäß zumindest einer Ausführungsform weist eine Oberfläche des Substrats, insbesondere die der Halbleiterschichtenfolge zugewandte Oberfläche des Substrats, die der Kontaktschicht zugewandte Oberfläche der Halbleiterschichtenfolge und/oder die der Halbleiterschichtenfolge abgewandte Oberfläche der Kontaktschicht, Erhebungen und Vertiefungen auf. Die Erhebungen und Vertiefungen können mittels einer regelmäßigen, insbesondere einer, vorzugsweise periodisch wiederkehrenden, Struktur oder einer unregelmäßigen Aufrauung ausgebildet sein. Derartige Strukturen können beispielsweise mittels Ätzen, vorzugsweise mit einer geeigneten Maske oder Sandstrahlen ausgebildet sein. Für eine unregelmäßige Aufrauung eignet sich beispielsweise Trockenätzen, z.B. reaktives Ionenätzen (RIE: Reactive Ion Etchhing), vorzugsweise unter Einsatz einer Metallmaske, oder nasschemisches Ätzen ohne Maskeneinsatz, während für eine regelmäßige Struktur nasschemisches Ätzen mit einer geeigneten Maske besonders geeignet ist. Eine strukturierte Oberfläche kann gegebenenfalls auch mittels Sandstrahlen ausgebildet sein.

Gemäß zumindest einer Ausführungsform enthält die Halbleiterschichtenfolge, insbesondere der aktive Bereich, die Zwischenschicht und/oder die Tunnelkontaktschicht beziehungsweise die Tunnelkontaktschichten, ein Nitrid-Verbindungshalbleitermaterial.

Gemäß zumindest einer Ausführungsform ist die Reflektorschicht und/oder die Spiegelschicht elektrisch leitfähig ausgeführt. Bevorzugt ist die Reflektorschicht und/oder die Spiegelschicht elektrisch leitend mit dem aktiven Bereich, dem Anschluss und/oder dem Gegenanschluss verbunden.

Gemäß zumindest einer Ausführungsform ist das Verhältnis des Flächeninhalts der der Halbleiterschichtenfolge zugewandten Oberfläche des Substrats oder der dem Substrat zugewandten Oberfläche der Halbleiterschichtenfolge zu dem Flächeninhalt einer den Halbleiterchip lateral begrenzenden Seitenfläche, insbesondere einer Seitenfläche des Substrats, kleiner oder gleich 2, bevorzugt kleiner oder gleich 1,5, besonders bevorzugt kleiner oder gleich 1,2. Bei vorgegebenen Kantenlängen des Chips können derartige Verhältnisse mittels eines Substrats mit einer geeignet ausgebildeten Dicke erzielt werden.

Vorzugsweise ist die Seitenfläche in diesem Zusammenhang unangeschrägt und ausnehmungsfrei ausgeführt. Die Seitenfläche verläuft bevorzugt im Wesentlichen senkrecht, zum Beispiel mit einer Abweichung von 5° oder weniger, vorzugsweise 2° oder weniger vom rechten Winkel, oder senkrecht zur lateralen Haupterstreckungsrichtung der Halbleiterschichtenfolge und/oder zu der der Halbleiterschichtenfolge zugewandten Oberfläche des Substrats.

Ein derartiger Halbleiterchip kann eine im Wesentlichen quaderförmige einhüllende Grundform aufweisen. Ein auf einem externen Anschlussleiter montierter quaderförmiger Chip ist bevorzugt derart auf dem Anschlussleiter montiert, dass sich die längeren Seiten von dem Anschlussleiter weg erstrecken ("säulenartige" Montage).

Bei einer Ausführung des Chips mit den obigen angegebenen Flächeninhaltsverhältnissen ist die Seitenfläche im Vergleich zur Chipoberfläche in Aufsicht auf den Halbleiterchip bevorzugt mit einem ähnlichen Flächeninhalt oder großflächiger ausgeführt. Die über die Seitenfläche zur Verfügung gestellte Strahlungsauskoppelfläche wird hierdurch vorteilhaft groß ausgebildet. In der Folge wird die Leuchtdichte an dieser Seitenfläche vorteilhaft verringert.

Für den Flächeninhalt der der Halbleiterschichtenfolge zugewandten Oberfläche des Substrats beziehungsweise der dem Substrat zugewandten Oberfläche der Halbleiterschichtenfolge kann, etwa bei einer Strukturierung der jeweiligen Oberfläche, gegebenenfalls der Inhalt der von dieser Oberfläche in lateraler Richtung überdeckten Fläche herangezogen werden.

Eine derartige Ausbildung des Chips ist für hochbrechende, vermehrt wellenführende Substrate, wie ein SiC-Substrat, von besonderem Vorteil, da aufgrund der Wellenführung im Substrat aus einer Substratseitenfläche eine erhöhte Strahlungsleistung auskoppeln kann. Aufgrund der großflächigen Ausführung der Seitenfläche kann die Leuchtdichte vereinfacht reduziert werden. Die Seitenfläche ist zur Auskopplung von Strahlung aus dem Chip zweckmäßigerweise unverspiegelt ausgeführt.

Mit wachsender Substratdicke wächst jedoch auch die gesamte Höhe des Halbleiterchips, insbesondere in Montageposition. Mit zunehmender Höhe und bei gleich bleibender lateraler Abmessung, wird eine zuverlässige Montage des Halbleiterchips auf einem Anschlussleiter erschwert. Insbesondere wird die Gefahr erhöht, dass der Halbleiterchip bei der Anordnung auf dem Anschlussleiter aufgrund des sich mit vergrößernder Höhe noch oben von der Montagefläche weg verlagernden Schwerpunkts des Chips umkippt.

Gemäß zumindest einer Ausführungsform ist das oben bezeichneten Flächeninhaltsverhältnis größer gleich 0,5, bevorzugt größer oder gleich 0,7, besonders bevorzugt größer oder gleich 0,8. Die Gefahr eines Umkippens des Chips bei der Anordnung auf einem Anschlussleiter kann so verringert werden.

Als sowohl für eine geringe Leuchtdichte an den Seitenflächen, als auch für hohe Montagezuverlässigkeit besonders geeignet hat sich ein Flächenverhältnis zwischen einschließlich 0,8 und 1,2 erwiesen. Ein derartiges Verhältnis kann mittels eines Chips mit einer würfelartigen einhüllenden Grundform erzielt werden.

Es sei angemerkt, dass alternativ oder zusätzlich auch über das Verhältnis der Dicke des Substrats zu einer Kantenlänge des Chips, etwa der größten oder der kleinsten Kantenlänge des Chips, die Seitenfläche des Substrats gegebenenfalls vorteilhaft großflächig ausgebildet werden kann. Insbesondere können die oben angegebenen Flächeninhalts-Verhältnisse auf diese Weise erzielt werden. Bevorzugt erfüllt das Verhältnis der jeweiligen Chipkantenlänge zu der Dicke des Substrats hierzu die oben angegebenen Relationen. Weiterhin ist die Dicke des Substrats bevorzugt in lateraler Richtung konstant.

Auch an einer auf der der Halbleiterschichtenfolgen abgewandten Seite des Substrats vorzugsweise vorgesehenen Spiegelschicht reflektierte Strahlung wird bei einer dicken Ausführung des Substrats bzw. einer Ausbildung der Flächeninhalte gemäß den obigen Ausführungen vermehrt über die Seitenfläche des Substrats ausgekoppelt. Die Volumenstrahlungseigenschaft des Halbleiterchips kann so verstärkt werden. Von besonderer Bedeutung ist dies für eine Halbleiterschichtenfolge auf Nitridverbindungshalbleiter-Basis auf einem demgegenüber höher brechenden Substrat, etwa einem SiC-haltigen Substrat. Bei einem derartigen Halbleiterchip wird Strahlung beim Übertritt von der Halbleiterschichtenfolge in das Substrat aufgrund der Brechungsindexrelation überwiegend zur Oberflächennormalen der Grenzfläche zum Substrat hin und somit in der Regel von der Seitenfläche weg gebrochen. Die auf die Spiegelschicht treffende Strahlungsleistung wird so gegenüber einem niedrig brechenden Substrat, z.B. einem Saphir-Substrat erhöht. Aufgrund der vergleichsweise dicken Ausführung des Substrats kann die an der Spiegelschicht reflektierte und über die Seitenfläche des Substrats ausgekoppelte Strahlungsleistung erhöht werden.

Ferner kann eine Mehrzahl von Seitenflächen des Substrats, insbesondere können alle Seitenflächen des Substrats die obigen Relationen erfüllen.

Gemäß zumindest einer Ausführungsform ist eine Dicke des Substrats kleiner oder gleich einer halben Kantenlänge des Halbleiterchips, insbesondere kleiner als eine halbe Kantenlänge des Substrats. Die Dicke des Substrats ist vorzugsweise die maximale Dicke. Weiterhin ist die Dicke des Substrats bevorzugt in lateraler Richtung konstant.

Bevorzugt ist die Dicke des Substrats kleiner als ein Drittel der Kantenlänge des Halbleiterchips. Das Substrat kann hierzu geeignet abgedünnt, beispielsweise abgeätzt oder abgeschliffen sein.

Als Kantenlänge kann eine minimale oder insbesondere maximale Kantenlänge des Chips, insbesondere in lateraler Richtung herangezogen werden.

Aufgrund des relativ dünnen Substrats trifft nur ein vergleichsweise geringer Anteil an Strahlung unmittelbar von der Halbleiterschichtfolge aus auf die entsprechend kleinflächige Seitenfläche des Substrats, so dass die Leuchtdichte an den Seitenflächen vorteilhaft verringert werden kann. Besonders zweckmäßig ist dies in Kombination mit einer Spiegelschicht auf der der Halbleiterschichtenfolge abgewandten Seite des Substrats, mittels derer, wie weiter oben beschrieben, Strahlung in Richtung der Halbleiterschichtenfolge und insbesondere durch eine strahlungsdurchlässige Kontaktschicht zurückreflektiert werden kann.
Gegenüber einem Chip mit einem vergleichsweise dicken Substrat (vergleiche die obigen Ausführungen) ist ein derartiger Chip zudem vereinfacht zuverlässig montierbar. Insbesondere ist die Gefahr eines Umkippens des Chips verringert. Bei einer elektrischen Kontaktierung des Halbleiterchips durch das Substrat weist ein derart "dünner" Chip ferner eine vorteilhaft geringe Vorwärtsspannung auf.
Im Hinblick auf eine Verringerung der Leuchtdichte an den Seitenflächen ist ein gegenüber der Halbleiterschichtenfolge hoch brechendes Substrat, etwa ein SiC-Substrat, besonders geeignet. Wie weiter oben bereits erwähnt werden Strahlen beim Übergang in das hoch brechende Substrat vermehrt von der Seitenfläche weg gebrochen. Die Leuchtdichte an der Seitenfläche kann so verringert werden. Gemäß der Erfindung umfasst der Halbleiterchip eine Halbleiterschichtenfolge, die einen zur Strahlungserzeugung geeigneten aktiven Bereich und eine laterale Haupterstreckungsrichtung aufweist, wobei die Halbleiterschichtenfolge auf einem Substrat angeordnet ist und der Halbleiterchip eine strahlungsdurchlässige und elektrisch leitfähige Kontaktschicht aufweist. Gemäß der Erfindung weist das Substrat eine Seitenfläche mit einem bezüglich der Haupterstreckungsrichtung angeschrägten Seitenflächenbereich und/oder einer Ausnehmung auf.
In einer zweiten Variante dieser Ausgestaltung ist der Brechungsindex des Substrats größer oder gleich dem Brechungsindex des aktiven Bereichs und/oder der Brechungsindex des Substrats ist größer oder gleich dem Brechungsindex einer die Halbleiterschichtenfolge auf der dem Substrat zugewandten Seite abschließenden Halbleiterschicht.
In einer dritten Variante dieser Ausgestaltung enthält die Halbleiterschichtenfolge ein Nitrid-Verbindungshalbleitermaterial und ein elektrischer Anschluss des Halbleiterchips sowie eine elektrische Gegenanschluss sind auf gegenüberliegenden Seiten der Halbleiterschichtenfolge angeordnet.
Mit einem Halbleiterchip gemäß diesen Varianten kann eine Steigerung der Auskoppeleffizienz des Halbleiterchips in erheblichem Maße erzielt werden. Die Vorteile der einzelnen Merkmale sind oben näher erläutert und können durch die entsprechenden Kombinationen in verstärktem Maße zum Tragen kommen.
Weitere Merkmale, vorteilhafte Ausgestaltungen und Zweckmäßigkeiten der Erfindung ergeben sich aus der folgenden Beschreibung der Ausführungsbeispiele in Verbindung mit den Figuren.
Figur 1 zeigt eine schematische Schnittansicht eines Ausführungsbeispiels eines optoelektronischen Halbleiterchips,
Figur 2 zeigt eine schematische Schnittansicht eines weiteren Ausführungsbeispiels eines optoelektronischen Halbleiterchips,
Figur 3 zeigt eine schematische Schnittansicht eines weiteren Ausführungsbeispiels eines optoelektronischen Halbleiterchips,
Figur 4 zeigt eine schematische Schnittansicht eines weiteren Ausführungsbeispiels eines optoelektronischen Halbleiterchips,
Figur 5 zeigt eine schematische Schnittansicht eines weiteren Ausführungsbeispiels eines optoelektronischen Halbleiterchips,
Figur 6 zeigt eine schematische Schnittansicht eines weiteren Ausführungsbeispiels eines optoelektronischen Halbleiterchips,
Figur 7 zeigt in Figur 7A eine schematische Schnittansicht eines Beispiels eines optoelektronischen Halbleiterchips und in den Figuren 7B sowie 7C zwei Varianten dieses Beispiels und
Figur 8 eine schematische Aufsicht auf ein Ausführungsbeispiel eines optoelektronischen Halbleiterchips.

Gleiche, gleichartige und gleich wirkende Elemente sind in den Figuren mit gleichen Bezugszeichen versehen.

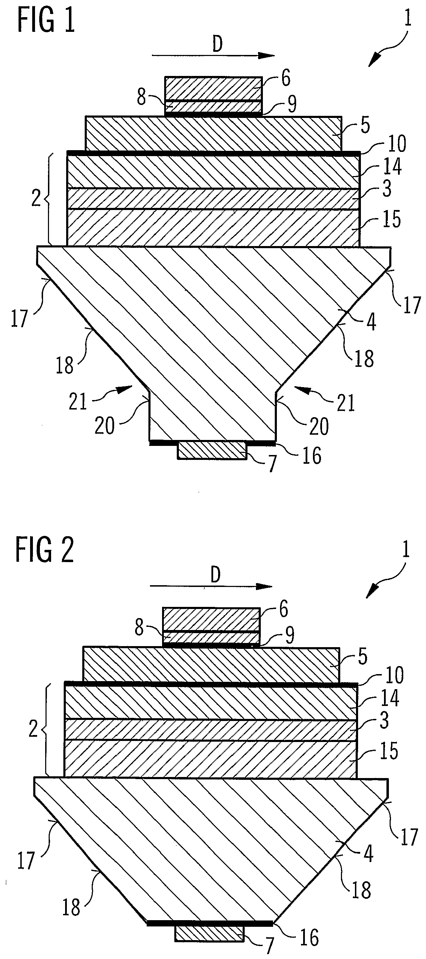

Der optoelektronische Halbleiterchip 1 umfasst gemäß den Ausführungsbeispielen nach den Figuren 1 bis 7 jeweils eine Halbleiterschichtenfolge 2, die einen zur Strahlungserzeugung geeigneten aktiven Bereich 3 umfasst und eine laterale Haupterstreckungsrichtung D aufweist. Zur effizienten Strahlungserzeugung ist der aktive Bereich 3 bevorzugt als Ein- oder Mehrfach-Quantentopfstruktur ausgeführt.

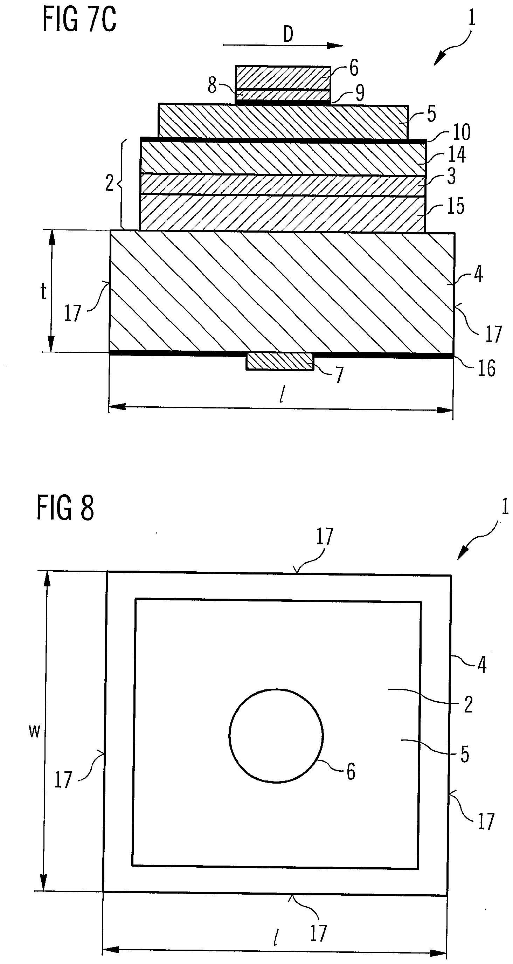

Die in den Figuren 1 bis 7 gezeigten Halbleiterchips können in Aufsicht gemäß der in Figur 8 gezeigten Aufsicht ausgeführt sein.

Die Halbleiterschichtenfolge 2 ist auf einem Substrat 4 angeordnet. Das Substrat 4 ist bevorzugt aus dem Aufwachssubstrat, auf dem die Halbleiterschichtenfolge 2 epitaktisch gewachsen ist, ausgebildet. Das Substrat 4 stabilisiert die Halbleiterschichtenfolge 2 mechanisch und trägt diese. Das Substrat kann zusätzlich abgedünnt sein, beispielsweise mittels Abschleifen oder Ätzen.

Weiterhin umfasst der Halbleiterchip 1 eine, vorzugsweise auf die vorgefertigte Halbleiterschichtenfolge aufgebrachte, strahlungsdurchlässige und elektrisch leitfähige Kontaktschicht 5. Die Kontaktschicht 5 ist auf der dem Substrat 4 abgewandten Seite der Halbleiterschichtenfolge 2 angeordnet. Bevorzugt grenzt die Kontaktschicht 5, insbesondere vollflächig, unmittelbar an die Halbleiterschichtenfolge 2 an. Die Kontaktschicht 5 ist mit dem aktiven Bereich 3 elektrisch leitend verbunden. Ferner ist die Kontaktschicht 5 vorzugsweise als durchgehende, ununterbrochene Schicht ausgeführt. Weiterhin erstreckt sich die Kontaktschicht 5 bevorzugt im Wesentlichen vollflächig abgesehen von randseitigen Aussparungen entlang der lateralen Haupterstreckungsrichtung über die Halbleiterschichtenfolge 2.

Die Kontaktschicht 5 kann beispielsweise mittels eines PVD-Verfahrens, z.B. mittels Aufdampfen, vorzugsweise unter Einsatz eines Elektronenstrahls (E-Beam Evaporation), oder Sputtern auf der Halbleiterschichtenfolge abgeschieden sein. Diese Verfahren sind für eine ITO-Kontaktschicht besonders geeignet. Auch ein CVD-Verfahren, insbesondere ein PECVD-Verfahren (PECVD: Plasma Enhanced Chemical Vapor Deposition), kann sich für das Abscheiden der Kontaktschicht, insbesondere für eine ZnO-Kontaktschicht, eignen.

Die Halbleiterschichtenfolge 2 ist zwischen einem elektrischen Anschluss 6 und einem elektrischen Gegenanschluss 7 angeordnet, die auf verschiedenen Seiten der Halbleiterschichtenfolge 2 angeordnet und zweckmäßigerweise elektrisch leitend mit dem aktiven Bereich 3 verbunden sind. Der elektrische Anschluss 6 ist auf der der Halbleiterschichtenfolge 2 abgewandten Seite der Kontaktschicht 5 angeordnet und elektrisch leitend mit der Kontaktschicht verbunden. Der Gegenanschluss 7 ist auf der der Halbleiterschichtenfolge 2 abgewandten Seite des Substrats 4 angeordnet.

Der Anschluss 6 ist vorzugsweise als Bondpad ausgeführt und demnach zur elektrisch leitenden Verbindung mit einem Bonddraht vorgesehen, mittels dem der Halbleiterchip 1 mit einem externen Anschlussleiter, etwa einem Anschlussleiter eines Gehäuses für ein Radial-Bauelement oder ein oberflächenmontierbares Bauelement, verbunden werden kann. Der elektrische Anschluss 6 ist vorzugsweise verglichen mit der Kontaktschicht 5 kleinflächig ausgeführt. Insbesondere überdeckt der elektrische Anschluss 6 bevorzugt ein einfach zusammenhängendes Gebiet der Kontaktschicht 5. Der elektrische Anschluss 6 kann beispielsweise im Wesentlichen in Aufsicht kreisförmig ausgeführt sein (vergleiche die Aufsicht in Figur 8).

Der elektrische Gegenanschluss 7 ist vorzugsweise zur elektrisch leitenden Verbindung mit einem weiteren externen Anschlussleiter mittels einer elektrisch leitenden Verbindungsschicht, beispielsweise einer Lot- oder einer Klebeschicht, vorgesehen. Weiterhin kann der elektrische Gegenanschluss die der Halbleiterschichtenfolge abgewandte Seite des Substrats vollständig (nicht explizit dargestellt) oder teilweise überdecken.

Über eine derartige Anordnung der Anschlüsse 6 und 7 auf verschiedenen Seiten der Halbleiterschichtenfolge kann verglichen mit einer Anordnung der Anschlüsse auf der gleichen Seite der Halbleiterschichtenfolge, insbesondere der dem Substrat abgewandten Seite, für Halbleiterchips gleicher auszukoppelnder Strahlungsleistung vereinfacht ein kleineres Chipraster gewählt werden. Zudem kann aufgrund der Verbindungsschicht auf eine weitere Drahtbondung verzichtet werden.

Zwischen dem aktiven Bereich 3 und dem elektrischen Anschluss 6 ist eine Reflektorschicht 8 angeordnet. Die Reflektorschicht 8 ist zweckmäßigerweise für im aktiven Bereich erzeugte Strahlung reflektierend ausgebildet. Die Reflektorschicht 8 ist vorzugsweise zwischen der Halbleiterschichtenfolge 2 und dem elektrischen Anschluss 6 und insbesondere zwischen der Kontaktschicht 5 und dem elektrischen Anschluss 6 angeordnet.

Zwischen dem elektrischen Anschluss 6 und dem aktiven Bereich 3 ist eine Haftvermittlungsschicht 9 angeordnet. Die Haftvermittlungsschicht 9 ist zwischen der Reflektorschicht 8 und der Halbleiterschichtenfolge 2 und zwischen der Reflektorschicht 8 und der Kontaktschicht 5 angeordnet. Bevorzugt grenzt die Haftvermittlungsschicht 9 unmittelbar an die Reflektorschicht 8 einerseits und die Kontaktschicht 5 andererseits an. Mittels der Haftvermittlungsschicht 9 kann die Haftung der Reflektorschicht 8 an der Kontaktschicht 5 erhöht werden.

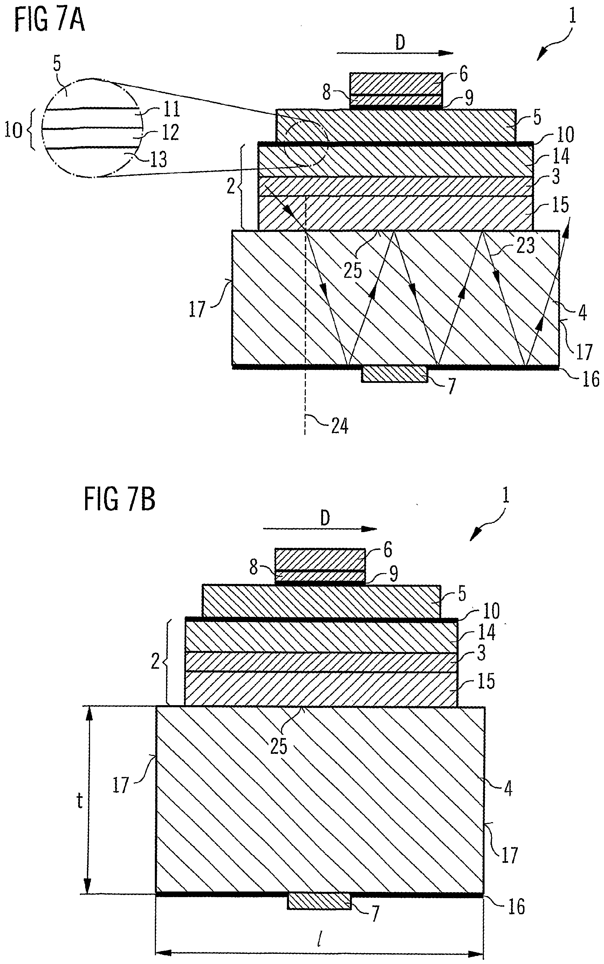

Weiterhin ist zwischen der Kontaktschicht 5 und dem aktiven Bereich 3 ein Tunnelkontakt 10 angeordnet. Der Tunnelkontakt 10 ist bevorzugt monolithisch im Halbleiterkörper integriert ausgeführt. Vorzugsweise umfasst der Tunnelkontakt 10 eine erste Tunnelkontaktschicht 11 und eine zweite Tunnelkontaktschicht 12 (vergleiche den exemplarisch lediglich im Zusammenhang mit Figur 7A explizit dargestellten Ausschnitt).

Die Tunnelkontaktschichten 11 und 12 weisen bevorzugt unterschiedliche Leitungstypen (n-leitend beziehungsweise p-leitend) auf. Besonders bevorzugt sind die Tunnelkontaktschichten hierzu unterschiedlich dotiert. Die Tunnelkontaktschicht 12 weist vorzugsweise den gleichen Leitungstypen auf wie eine seitens des aktiven Bereichs 3 an den Tunnelkontakt 10 angrenzende Halbleiterschicht 13 der Halbleiterschichtenfolge 2, zum Beispiel p-leitend. Vorzugsweise sind die Tunnelkontaktschichten 11, 12 hochdotiert ausgeführt. Die Tunnelkontaktschicht 12 ist vorzugsweise p-leitend und die Tunnelkontaktschicht 11 ist vorzugsweise n-leitend ausgebildet. Eine Dotierstoffkonzentration von 1*10¹⁹ 1/cm³ oder größer, bevorzugt 1*10²⁰ 1/cm³ oder größer hat sich für die Tunnelkontaktschichten als besonders geeignet erwiesen. Mittels des Tunnelkontakts kann die elektrische Anbindung der Kontaktschicht 5, die vorzugsweise unmittelbar an den Tunnelkontakt angrenzt, an den aktiven Bereich verbessert werden. Mittels des Tunnelkontakts kann vereinfacht ein spannungsverlustarmer Kontakt, insbesondere ein ohmscher Kontakt zwischen der Kontaktschicht 5 und der Halbleiterschichtenfolge 2 realisiert werden.

Die Dicke der Tunnelkontaktschichten liegt bevorzugt zwischen jeweils einschließlich 3 nm und 20 nm.

Der aktive Bereich 3 ist vorzugsweise zwischen Halbleiterschicht(en) 14 und 15, die unterschiedliche Leitungstypen aufweisen, angeordnet. Die Halbleiterschicht(en) 14 können beispielsweise p-leitend und die Halbleiterschicht(en) 15 können beispielsweise n-leitend ausgeführt sein. Die Halbleiterschicht(en) 14 und 15 können insbesondere jeweils eine Barriere- oder Mantelschicht aufweisen, mittels derer der Ladungsträgereinschluss im aktiven Bereich verbessert wird. Darüber kann die interne Quanteneffizienz des Halbleiterchips erhöht werden.

Zusätzlich zu den Tunnelkontaktschichten 11, 12 kann der Tunnelkontakt 10 eine zwischen diesen Schichten angeordnete, undotierte Zwischenschicht aufweisen (nicht explizit dargestellt). Diese Zwischenschicht ist bevorzugt als Diffusionsbarriereschicht ausgebildet und behindert die Diffusion eines Akzeptors, z.B. Mg, aus der p-leitenden zweiten Tunnelkontaktschicht 12 bzw. den p-leitende(n) Halbleiterschicht(en) 14 in die n-leitende erste Tunnelkontaktschicht 11 oder blockiert eine derartige Diffusion vollständig. Die Gefahr einer durch die Diffusion des Dotierstoffs verursachten Schädigung des Chips kann so verringert werden.

Weiterhin kann eine Tunnelkontaktschicht 11 bzw. 12 oder eine Mehrzahl von Tunnelkontaktschichten als Mehrschichtstruktur, etwa als Übergitterstruktur, ausgeführt sein (nicht explizit dargestellt).

Die Zwischenschicht weist bevorzugt eine Dicke von 10 nm oder weniger auf. Gegebenenfalls kann eine Dicke der Zwischenschicht von einer Monolage für eine Diffusionsbarriere bereits ausreichen.

Auf der der Halbleiterschichtenfolge 2 abgewandten Oberfläche des Substrats 4 ist eine Spiegelschicht 16 angeordnet. Die Spiegelschicht 16 kann beispielsweise auf das Substrat aufgebracht, zum Beispiel aufgesputtert oder aufgedampft, sein. Weiterhin kann die Spiegelschicht 16 zwischen dem Gegenanschluss 7 und dem Substrat 4 oder lateral neben dem Gegenanschluss angeordnet sein.

Die Halbleiterschichtenfolge 2 basiert bevorzugt auf Nitrid-Verbindungshalbleitermaterialien. Derartige Materialien sind wie bereits weiter oben erwähnt zur Erzeugung kurzwelliger Strahlung besonders geeignet. Insbesondere enthalten die Tunnelkontaktschichten 11 und 12 die Halbleiterschicht(en) 13, 14 und 15 sowie der aktive Bereich 3 bevorzugt ein Material aus dem Materialsystem AlₙGaₘIn₁₋ₙ₋ₘN. Der aktive Bereich enthält bevorzugt InGaN. Die erste Tunnelkontaktschicht 11 und/oder die zweite Tunnelkontaktschicht 12 kann GaN, AlGaN, InGaN oder InAlGaN enthalten oder daraus bestehen. Die Zwischenschicht kann AlN, GaN, AlGaN, InGaN oder InAlGaN enthalten oder daraus bestehen.

Der elektrische Anschluss 6, der elektrische Gegenanschluss 7, die Reflektorschicht 8, die Haftvermittlungsschicht 9 und/oder die Spiegelschicht 16 enthalten bevorzugt ein Metall und sind besonders bevorzugt metallisch oder auf Legierungsbasis ausgeführt. Für die Anschlüsse 6 und 7 eignet sich beispielsweise Au, für die Reflektorschicht 8, insbesondere für hohe Reflektivitäten für Strahlung die mittels Nitrid-Verbindungshalbleitern erzeugbar ist, besonders Al oder Ag. Entsprechendes gilt für die reflektierende Spiegelschicht 16. Die Haftvermittlungsschicht 9 enthält bevorzugt Pt oder Pd. Derartige Materialien sind für die Haftvermittlung zum Halbleiterchip besonders geeignet.

Eine Dicke der Haftvermittlungsschicht ist bevorzugt kleiner oder gleich 1 nm. Die Haftvermittlungsschicht kann insbesondere inselartig ausgeführt sein.

Die strahlungsdurchlässige und elektrisch leitfähige Kontaktschicht 5 enthält bevorzugt ein TCO-Material, zum Beispiel ZnO:Al oder ein ITO. Für eine besonders hohe Querleitfähigkeit eines n-leitenden ITO eignet sich besonders ein ITO in unterstöchiometrischer Zusammensetzung, z.B. mit Sauerstoff-Fehlstellen, oder ein ITO mit einem Verhältnis von Indiumoxid zu Zinnoxid von 90:10 oder größer, z.B. 95:5. Eine Dicke der Kontaktschicht liegt bevorzugt zwischen einschließlich 100 nm und 1000 nm, hinsichtlich gleichzeitig guter Stromaufweitung und ökonomischem Materialeinsatz besonders bevorzugt zwischen einschließlich 100 nm und 300 nm.

Über den vergleichsweise kleinflächig ausgeführten Anschluss 6, die Reflektorschicht 8 und die Haftvermittlungsschicht 9 wird in einem vergleichsweise kleinen Injektionsbereich Strom in die Kontaktschicht 5 injiziert. Dieser Strom wird in der TCO-Kontaktschicht aufgrund der hohen Querleitfähigkeit in lateraler Richtung verteilt. Der aktive Bereich 3 kann so trotz des vergleichsweise kleinflächigen elektrischen Anschusses 6 großflächig und homogen bestromt werden. Gleichzeitig zeichnen sich TCO-Materialien durch hohe Strahlungsdurchlässigkeit aus, sodass im aktiven Bereich erzeugte Strahlung im Gegensatz zu einer vergleichsweise großflächig aufgebrachten Kontaktmetallisierung die Kontaktschicht vereinfacht durchstrahlen kann.

Da die laterale Stromverteilung über die Kontaktschicht 5 erfolgt, kann der gegebenenfalls absorbierende Anschluss 6 vorteilhaft kleinflächig ausgeführt werden.

Über die Reflektorschicht 8 wird eine Absorption von im aktiven Bereich 3 erzeugter Strahlung im elektrischen Anschluss 6 vermindert. Die Reflektorschicht 8 reflektiert vom aktiven Bereich 3 aus auf diese treffende Strahlung vorzugsweise in die Halbleiterschichtenfolge 2 zurück, so dass die Strahlung gegebenenfalls aus dem Halbleiterchip 1 ausgekoppelt werden kann. Über die Haftvermittlungsschicht 9 wird die Haftung der Reflektorschicht 8 an der Kontaktschicht 5 vorteilhaft erhöht, so dass die Gefahr einer Ablösung des Schichtstapels mit dem Anschluss und der Reflektorschicht von der Kontaktschicht und somit die Gefahr eines Chipdefektes verringert wird.

Über die Spiegelschicht 16 kann im aktiven Bereich 3 erzeugte Strahlung, die auf die der Halbleiterschichtenfolge 2 abgewandte Oberfläche des Substrats 4 trifft, in Richtung der Halbleiterschichtenfolge zurückreflektiert werden, wodurch die Gefahr einer Absorption von im Halbleiterchip 1 erzeugte Strahlung in auf der der Halbleiterschichtenfolge 2 abgewandten Seite der Spiegelschicht 16 angeordneten Elementen, etwa einem externen Anschlussleiter oder auch dem Gegenanschluss 7, verringert wird.

Über den Tunnelkontakt 10 wird bevorzugt die elektrische Anbindung der Kontaktschicht an die Halbleiterschichtenfolge verbessert. Insbesondere kann die Verlustspannung am Übergang Kontaktschicht/Halbleiterschichtenfolge verringert werden. Von besonderer Bedeutung ist dies, falls sich ohne einen Tunnelkontakt eine hohe Potentialbarriere einer maßgeblichen Dicke zwischen der Kontaktschicht 5 und den Halbleiterschicht(en) 14 ausbilden würde. Dies kann beispielsweise bei n-leitendem ITO oder ZnO:Al der Fall sein.

Alternativ zum Vorsehen eines Tunnelkontakts 10 mit zwei Tunnelkontaktschichten unterschiedlichen Leitungstyps kann gegebenenfalls auch ohne einen Tunnelkontakt ein guter elektrischer Kontakt, vorzugsweise ein ohmscher Kontakt, zwischen der Kontaktschicht 5 und dem Halbleiterkörper 2 ausgebildet werden.

Insbesondere kann hierzu eine an die strahlungsdurchlässige Kontaktschicht angrenzende Anschlussschicht im Halbleiterkörper integriert sein. In diesem Fall kann auf die Schicht 11 des Tunnelkontaktes (vgl. Figur 7A) verzichtet werden und die Schicht 12 kann als Anschlussschicht dienen.

Diese Anschlussschicht ist zweckmäßigerweise für die Kontaktbildung zu der strahlungsdurchlässigen Kontaktschicht optimiert. Die Anschlussschicht ist vorzugsweise dotiert ausgeführt. Für eine Kontaktbildung zur Kontaktschicht hat es sich als besonders vorteilhaft herausgestellt, dass die Anschlussschicht auf der der Kontaktschicht zugewandten Seite und insbesondere in dem Kontaktbereich, in dem die Anschlussschicht an die Kontaktschicht angrenzt, eine andere Dotierstoffkonzentration aufweist, als in einem Bereich der Anschlussschicht, der weiter von der Kontaktschicht entfernt und insbesondere näher an dem aktiven Bereich angeordnet ist. Bevorzugt ist die Dotierstoffkonzentration in der Anschlussschicht seitens der Kontaktschicht größer als seitens des aktiven Bereichs.

Die unterschiedlichen Dotierstoffkonzentrationen in der Anschlussschicht können insbesondere deutlich voneinander abweichen. Eine Abweichung der beiden Dotierstoffkonzentrationen voneinander beträgt bevorzugt 30 % oder mehr, besonders bevorzugt 40 % oder mehr. Die Dotierstoffkonzentration in der Anschlussschicht kann in dem Bereich nahe der Kontaktschicht, insbesondere im unmittelbaren Kontaktbereich, das 1,3-fache oder mehr, bevorzugt das 1,4-fache oder mehr der Dotierstoffkonzentration in einem von der Kontaktschicht weiter entfernten und näher am aktiven Bereich angeordneten Bereich der Anschlussschicht betragen.

Die Anschlussschicht enthält vorzugsweise ein Nitrid-Verbindungshalbleitermaterial. Die Anschlussschicht kann beispielsweise GaN enthalten oder daraus bestehen. Weiterhin ist die Anschlussschicht vorzugsweise p-leitend dotiert ausgeführt. Als besonders geeignet hat es sich herausgestellt, Mg als Akzeptor für die p-Dotierung einzusetzen.

Als für einen geringen Kontaktwiderstand zwischen der Kontaktschicht und der Anschlussschicht besonders geeignet hat sich eine Dotierstoffkonzentration in der Anschlussschicht seitens der Kontaktschicht von 3 * 10¹⁹ cm⁻³ oder mehr, z.B. von zwischen einschließlich 3 * 10¹⁹ cm⁻³ und einschließlich 5 * 10²⁰ cm⁻³, erwiesen. In einem von der Kontaktschicht entfernten Bereich der Anschlussschicht kann diese eine Dotierstoffkonzentration von 2 * 10¹⁹ cm⁻³ oder weniger aufweisen. Bei einer im Inneren der Anschlussschicht gegenüber dem Grenzbereich zur Kontaktschicht verringerten Dotierstoffkonzentration kann die Konzentration an freien Ladungsträger in der Anschlussschicht und somit die Leitfähigkeit in Richtung des aktiven Bereichs höher sein als im Falle einer über den Schichtverlauf, insbesondere senkrecht zur lateralen Haupterstreckungsrichtung, gleichbleibend hohen Dotierstoffkonzentration. Eine hohe Dotierstoffkonzentration im Kontaktbereich zur Kontaktschicht erleichtert jedoch das Ausbilden eines niederohmigen, und damit verlustarmen elektrischen Kontaktes der Kontaktschicht zum aktiven Bereich. Insbesondere kann so vereinfacht ein ohmscher elektrischer Kontakt zum Halbleiterkörper erzielt werden.

Eine Dicke der Anschlussschicht kann 30 nm oder mehr, besonders bevorzugt 50 nm oder mehr oder sogar 100nm oder mehr betragen.

Eine derartige Anschlussschicht ist in der WO 03/043092 beschrieben, deren gesamter Offenbarungsgehalt insoweit durch Rückbezug explizit in die vorliegende Patentanmeldung aufgenommen wird. Überraschenderweise hat sich herausgestellt, dass eine derart ausgebildete Anschlussschicht nicht nur für die Kontaktbildung zwischen stark absorbierenden Metallisierungen und Halbleitermaterialien, sondern auch für die elektrische Kontaktbildung eines Halbleiterkörpers zu einer strahlungsdurchlässigen Kontaktschicht, insbesondere zu einer TCO-Kontaktschicht besonders geeignet ist.

Das Substrat 4 enthält beispielsweise SiC, vorzugsweise SiC:N, oder, vorzugsweise n-leitend dotiertes, GaN. Insbesondere ist das Substrat 4 vorzugsweise elektrisch leitfähig ausgeführt, sodass die elektrische Kontaktierung des aktiven Bereichs 3 durch das Substrat erfolgen kann. Weiterhin ist das Substrat vorzugsweise strahlungsdurchlässig für die im aktiven Bereich erzeugte Strahlung ausgebildet, sodass das Substrat vereinfacht auch zur Strahlungsauskopplung von Strahlung aus dem Halbleiterchip genutzt werden kann.

Weiterhin weisen die oben für das Substrat angeführten Materialien - GaN und SiC - für eine Halbleiterschichtenfolge auf Nitrid-Verbindungshalbleiterbasis einen Brechungsindex auf, der größer (für SiC) oder gleich (für GaN) dem (gegebenenfalls mittleren) Brechungsindex der Halbleiterschichtenfolge, insbesondere des aktiven Bereichs und/oder einer die Halbleiterschichtenfolge seitens des Substrats 4 begrenzenden Halbleiterschicht der Halbleiterschicht(en) 15 ist. Der Brechungsindex von SiC beträgt ungefähr 2,7, ein typischer Brechungsindex eines Materials aus dem Materialsystem (In,Al)GaN ungefähr 2,5. Der Strahlungsübertritt von Strahlung aus der Halbleiterschichtenfolge 2 in das Substrat 3 wird aufgrund der verminderten oder vollständig entfallenden Totalreflexion an der Grenzfläche von Halbleiterschichtenfolge und Substrat, insbesondere gegenüber einem Saphir-Substrat, das einen kleineren Brechungsindex als GaN-basierte Materialien aufweist, erleichtert.
Weiterhin kann bei einem hoch brechenden Substrat das Substrat vereinfacht zur Strahlführung von Strahlung in Richtung der Seitenflächen 17 des Substrats dienen. Das Substrat kann insbesondere zur Wellenleitung ausgeführt sein. Durch Reflexion an der der Halbleiterschichtenfolge abgewandten Oberfläche des Substrats, insbesondere durch Reflexion an der Spiegelschicht und (Total)Reflexion an der der Halbleiterschichtenfolge zugewandten Oberfläche des Substrats kann die Strahlung in Richtung der Seitenflächen geführt werden. Die Seitenflächen 17 können dann vermehrt der Strahlungsauskopplung aus dem Halbleiterchip 1 dienen. Die Ausbildung des Halbleiterchips als Volumenstrahler mit vergleichsweise geringer Oberflächenleuchtdichte wird durch eine Nutzung des Substrats zur Auskopplung erleichtert.
Eine derartige Strahlführung im Substrat in Richtung der Seitenflächen 17 ist bei einem Halbleiterchip 1 gemäß dem Beispiel in Figur 7 (Figuren 7A, 7B und 7C), der im Wesentlichen senkrecht zur Haupterstreckungsrichtung D der Halbleiterschichtenfolge 2 verlaufende Seitenflächen 17 und zwei im Wesentlichen senkrecht zu diesen Seitenflächen verlaufende Oberflächen aufweist, von besonderem Vorteil.

Diese Strahlführung im Substrat 4 ist anhand des Strahls 23 in Figur 7A schematisch angedeutet. Hierbei wurde ein gegenüber der Halbleiterschichtenfolge 2 höher brechendes Substrat, beispielsweise ein SiC-Substrat für eine Halbleiterschichtenfolge auf (In,Al)GaN-Basis angenommen. Dementsprechend wird der Strahl 23 beim Eintritt in das Substrat 4 zur Oberflächennormalen 24 der der Halbleiterschichtenfolge 2 zugewandten Oberfläche 25 des Substrats 4 hin gebrochen. Nach Reflexion(en) an der Spiegelschicht 16 und Totalreflexion(en) an der Oberfläche 25 koppelt der Strahl über die Seitenfläche 17 aus dem Substrat 4 aus.

In den Figuren 7B und 7C sind zwei vorteilhafte Ausführungsformen eines Halbleiterchips gemäß Figur 7A dargestellt.

Das Substrat 4 weist dabei jeweils eine Dicke t auf. Die Länge 1 gibt ebenso wie die Länge w eine Kantenlänge des Chips (vergleiche die Aufsicht in Figur 8).

Die Kantenlängen 1 und w können verschieden sein, sind aber bevorzugt gleich groß, so dass der Chip in Aufsicht quadratartig ausgeführt ist. Ferner entspricht die Kantenlänge 1 bevorzugt der Länge des Substrats. Die Dicke t ist vorzugsweise in lateraler Richtung konstant ausgeführt.

Typische Chipkantenlängen 1, w liegen zwischen einschließlich 200 µm und einschließlich 300 µm, beispielsweise bei 250 µm.

Im Beispiel gemäß Figur 7B ist das Substrat mit einer Dicke t und einer Länge ausgeführt, die der Kantenlänge 1 entspricht. Der Flächeninhalt der Seitenflächen 17 beträgt damit bei gleichen Kantenlängen (l=w) jeweils l*t, bei verschiedenen Kantenlängen l*t bzw. w*t. Das Verhältnis l:t liegt bevorzugt zwischen jeweils einschließlich 0,8 und 1,2. Der Chip kann insbesondere würfelartig ausgeführt sein. Besonders bevorzugt ist hierbei zusätzlich l=t.
Die Flächeninhalte der Oberfläche 25 (l*w) und der jeweiligen Seitenflächen 17 des Substrats (l*t bzw. l*w) verhalten sich bei gleichen Kantenlängen l und w ebenfalls wie l:t.
Die Leuchtdichte an den Seitenflächen 17 kann über derartige Dimensionierung der Flächeninhalte bei gleichzeitig zuverlässiger Montierbarkeit des Chips vorteilhaft verringert werden. Das Substrat wird bevorzugt mit einer derartigen Dicke bereitgestellt oder gegebenenfalls auf eine derartige Dicke abgedünnt.

Da die Halbleiterschichtenfolge gegenüber den Chipabmessungen vergleichsweise dünn ist, bestimmt die Substratdicke die Chiphöhe maßgeblich. Der gesamte Chip kann insbesondere mit einer würfelartigen einhüllenden Grundform ausgeführt sein.

Im Besipiel gemäß Figur 7C ist die Dicke t des Substrats 4 kleiner oder gleich (1/2)*l vorzugsweise kleiner oder gleich (1/3)*l. Die Dicke des Substrats kann beispielsweise 100 µm oder weniger, bevorzugt 80 µm oder weniger betragen. Das Substrat 4 ist hierzu zweckmäßigerweise entsprechend abgedünnt. Das Abdünnen erfolgt vorzugsweise nach dem Aufwachsen der Halbleiterschichtenfolge 2 auf dem Substrat 4. Mit einer derart dünnen Ausbildung des Substrats kann ein besonders flacher und dementsprechend Platz sparender Halbleiterchip geschaffen werden. Zudem kann bei einem elektrisch leitenden Substrat die Vorwärtsspannung vorteilhaft verringert werden.

Zweckmäßigerweise ist das Substrat ein gegenüber der Halbleiterschichtenfolge hoch brechendes Substrat, wie ein SiC-Substrat im Falle einer Halbleiterschichtenfolge auf Nitridverbindungshalbleiter-Basis. Gegenüber einem niedrig brechenden Substrat wie einem Saphirsubstrat, das einen Brechungsindex kleiner dem von Nitrid-Verbindungshalbleitermaterialien aufweist, verlaufen im aktiven Bereich 3 erzeugte Strahlen im Substrat vermehrt steiler, das heißt mit kleineren Winkeln zur Oberflächennormalen 24. Der Anteil an nach einer Reflexion an der Spiegelschicht 16 wieder in die Halbleiterschichtenfolge 2 eintretenden und über die dem Substrat 4 abgewandte Seite der Halbleiterschichtenfolge 2 aus dem Chip 1 auskoppelnden Strahlung kann so erhöht werden. Gegenüber einem Halbleiterchip mit einem niedrig brechenden Substrat wird die Leuchtdichte an den Seitenflächen 17 vorteilhaft verringert.

Die in den Figuren 1 bis 6 gezeigten Ausführungsbeispiele des Halbleiterchips weisen im Unterschied zu Figur 7 ein Substrat 4 mit bezüglich der Haupterstreckungsrichtung D, insbesondere unter einem spitzen Winkel zu dieser Richtung angeschrägten Seitenflächenbereichen 18 auf. Über derartige Anschrägung kann, insbesondere bei den Ausführungsbeispielen gemäß Figur 1, 2, 4, 5 und 6, der unmittelbar über den angeschrägten Seitenflächenbereich 18 ausgekoppelte Strahlungsanteil erhöht werden.

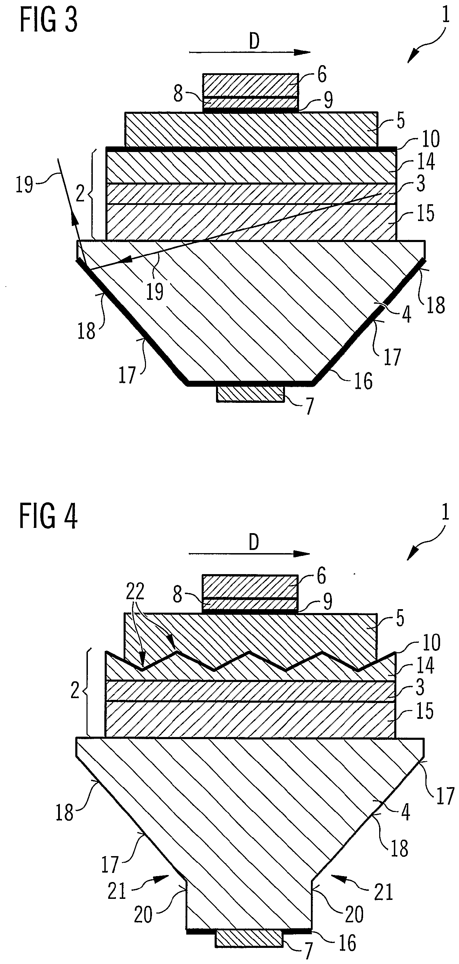

Beim Ausführungsbeispiel gemäß Figur 3 erstreckt sich die durchgehende Spiegelschicht 16 auch entlang der Seitenfläche 17 und insbesondere entlang des angeschrägten Seitenflächenbereichs 18. Hierdurch kann die durch einen nicht von der Halbleiterschichtenfolge bedeckten Teilbereich der der Halbleiterschichtenfolge 2 zugewandten Oberfläche des Substrats 4 aus dem Chip ausgekoppelte Strahlungsleistung mittels Reflexion an der Spiegelschicht 16 erhöht werden. Dies ist anhand des Strahls 19 in Figur 3 schematisch angedeutet.

Bei den Ausführungsbeispielen gemäß den Figuren 1, 4, 5 und 6 weist das Substrat Seitenflächenbereiche 20 auf, die parallel zueinander und insbesondere im Wesentlichen senkrecht zur Haupterstreckungsrichtung D der Halbleiterschichtenfolge 2 verlaufen. Die Seitenflächenbereiche 20 sind den angeschrägten Seitenflächenbereichen 18 von der Halbleiterschichtenfolge 2 aus gesehen vorzugsweise nachgeordnet. An den Seitenflächenbereichen 20 kann der Halbleiterchip 1 vereinfacht mit einem Montagewerkzeug erfasst und auf einem externen elektrischen Anschlussleiter positioniert und daraufhin auf diesem befestigt und elektrisch kontaktiert werden.

Das Substrat 4 verjüngt sich hierbei im Bereich der angeschrägten Seitenflächenbereiche 18 mit wachsendem Abstand von der Halbleiterschichtenfolge 2 und weist im Bereich der Seitenflächenbereiche 20 einen im Wesentlichen konstanten Querschnitt auf. Insbesondere ist bei diesen Ausführungsbeispielen im Substrat 4 eine sich von der der Halbleiterschichtenfolge 2 abgewandten Oberfläche des Substrats in Richtung der Halbleiterschichtenfolge erstreckenden Ausnehmung 21 im Substrat gebildet. Die Seitenfläche kann in dem Bereich, in dem sich das Substrat verjüngt oder im Bereich der Ausnehmung, eine treppenartige Struktur aufweisen oder gekrümmt sein (nicht explizit dargestellt). Die in diesem Bereich unmittelbar aus dem Substrat ausgekoppelte Strahlungsleistung kann so weitergehend erhöht werden.

Bei den Ausführungsbeispielen gemäß den Figuren 4, 5 und 6 weist der Halbleiterchip 1 Erhebungen und Vertiefungen 22 auf. Mittels derartiger Erhebungen und Vertiefungen kann der Reflexionswinkel für Reflexion von Strahlung an den jeweiligen, die Erhebungen und Vertiefungen aufweisenden Grenzflächen beeinflusst werden. Insbesondere kann eine Totalreflexion an diesen Grenzflächen gestört werden. Die aus dem Halbleiterchip 1 ausgekoppelte Strahlungsleistung kann so erhöht werden.

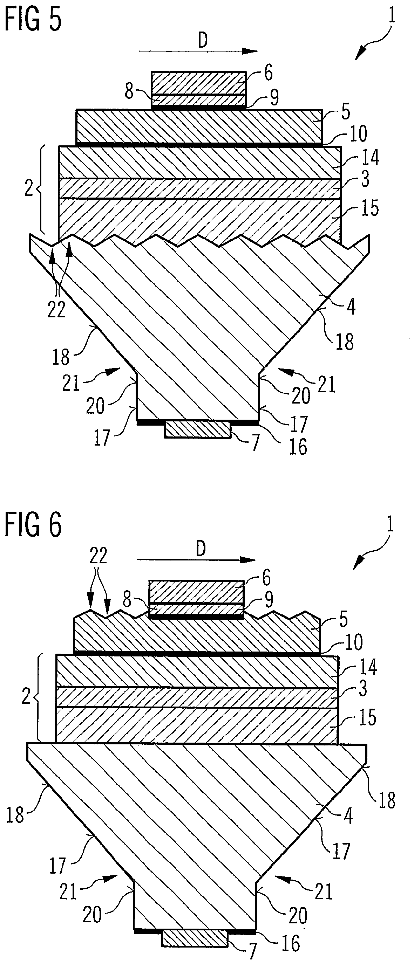

Die Erhebungen und Vertiefungen 22 können beispielsweise in der der Halbleiterschichtenfolge abgewandten Seite der Kontaktschicht 5 (Figur 6), der dem Substrat 4 abgewandten Seite der Halbleiterschichtenfolge 2 (Figur 4) oder in der der Halbleiterschichtenfolge 2 zugewandten Seite des Substrats (Figur 5) ausgebildet sein. Die Tiefe einer Vertiefung oder einer Mehrzahl von Vertiefungen, vorzugsweise aller Vertiefungen in der jeweiligen Schicht beträgt bevorzugt 100 nm oder mehr. Auf diese Weise kann die Reflexion an der jeweiligen strukturierten Grenzfläche besonders effizient gestört werden. Die Erhebungen und Vertiefungen können als regelmäßige Strukturen, mit einer wiederkehrenden, vorzugsweise periodischen Anordnung der Erhebungen und Vertiefungen, oder als unregelmäßige Aufrauung mit einer unregelmäßigen, vorzugsweise im Wesentlichen statistischen Verteilung der Erhebungen und Vertiefungen ausgeführt sein. Die Erhebungen und Vertiefungen können in der jeweiligen Schicht zum Beispiel wie weiter oben bereits beschrieben über Ätzen oder Sandstrahlen ausgebildet werden.

Ein Halbleiterchip ähnlich den in den Figuren 1, 4, 5 und 6 gezeigten Halbleiterchips ist in der WO 01/61764 oder der WO 01/61765 beschrieben, deren gesamter Offenbarungsgehalt insoweit hiermit explizit durch Referenz in die vorliegende Patentanmeldung aufgenommen wird. Die in diesen Figuren schematisch dargestellte Formgebung des Substrats 4 kann durch ein entsprechend geformtes Sägeblatt, das zum Vereinzeln des Chips aus dem Waferverbund eingesetzt wird, erreicht werden. Die gesägten Seitenflächen und insbesondere auch das Substrat bedürfen für diese Formgebung keiner weiteren Bearbeitung.

Gegenüber den in der WO 01/61764 oder der WO 01/61765 beschriebenen Chips kann im Rahmen der Erfindung die Auskoppeleffizienz des Halbleiterchips um 30% oder mehr, insbesondere bis zu 50%, erhöht werden.

Insgesamt kann mittels den oben beschriebenen Halbleiterchips ein volumenstrahlender Halbleiterchip mit verringerter Oberflächenleuchtdichte, erhöhter Auskoppeleffizienz sowie aufgrund der strahlungsdurchlässigen elektrisch leitfähigen Kontaktschicht hoher Stromtragfähigkeit und damit einer erhöhten ESD-Festigkeit ausgebildet werden.

Ein derartiger Halbleiterchip ist beispielsweise zur Hinterleuchtung, z.B. einer Anzeigevorrichtung, zur Beleuchtung oder zur Visualisierung, z.B. als Pixel oder als Teil eines Pixels in einem Display oder für den Einsatz in einer Projektionsvorrichtung besonders geeignet.

Aufgrund der Anordnung des Anschlusses und des Gegenanschlusses auf verschiedenen Seiten der Halbleiterschichtenfolge kann der Halbleiterchip seitens des Gegenanschlusses auf einfache Weise mittels eines elektrisch leitfähig ausgebildeten Klebstoffs, z.B. Silberleitkleber, oder einem Lot auf einem externen Anschlussleiter montiert und elektrisch kontaktiert werden. Bei einem Chip mit beiden Anschlüssen auf der gleichen Seite der
Halbleiterschichtenfolge, sind zur Kontaktierung entweder zwei Drahtbondungen oder, bei einer Flip-Chip-Montage, Klebeverbindungen in unmittelbarer Nähe zueinander sowie zur Halbleiterschichtenfolge und dem aktiven Bereich erforderlich. Drahtbondungen sind gegenüber einer Klebeverbindung vergleichsweise aufwendig herzustellen, während bei einer Flip-Chip-Montage mit Klebeverbindungen auf einem Anschlussleiter die Gefahr eines Kurzschlusses des Chips erhöht ist.

Die Erfindung ist nicht durch die Beschreibung anhand der Ausführungsbeispiele beschränkt.

## Patentansprüche

1. Optoelektronischer Halbleiterchip (1) mit einem Anschluss (6), einer Haftvermittlungsschicht (9), einer Reflektorschicht (8) und einer Halbleiterschichtenfolge (2), die einen zur Strahlungserzeugung geeigneten aktiven Bereich (3) umfasst und eine laterale Haupterstreckungsrichtung aufweist, wobei
- die Halbleiterschichtenfolge auf einem Substrat (4) angeordnet ist, das eine Seitenfläche (17) aufweist,
die Seitenfläche einen bezüglich der Haupterstreckungsrichtung angeschrägten Seitenflächenbereich (18) und/oder eine Ausnehmung (21) aufweist,
- der Halbleiterchip eine strahlungsdurchlässige und elektrisch leitfähige Kontaktschicht (5) aufweist,
- eine an die Kontaktschicht (5) angrenzende Anschlussschicht in der Halbleiterschichtenfolge angeordnet ist, welche eine Dotierstoffkonzentration aufweist, die seitens der Kontaktschicht (5) größer ist als seitens des aktiven Bereichs (3),
- zwischen dem aktiven Bereich (3) und dem Anschluss (6) die Reflektorschicht (8) angeordnet ist, und
- die Haftvermittlungsschicht (9) zwischen der Reflektorschicht (8) und der Kontaktschicht (5) angeordnet ist, und die Haftung der Reflektorschicht an der Kontaktschicht erhöht.

2. Halbleiterchip nach dem vorhergehenden Anspruch,
bei dem die Kontaktschicht (5) ein strahlungsdurchlässiges und elektrisch leitfähiges Oxid, insbesondere ein Metalloxid, beispielsweise ein Indiumoxid, ein Zinnoxid, ein Indiumzinnoxid oder ein Zinkoxid, enthält.

3. Halbleiterchip nach Anspruch 2,
bei dem die Halbleiterschichtenfolge (2), insbesondere der aktive Bereich (3), ein Nitrid-Verbindungshalbleitermaterial enthält.

4. Halbleiterchip nach mindestens einem der vorhergehenden Ansprüche 2 oder 3,
bei dem der Brechungsindex des Substrats (4) größer oder gleich dem Brechungsindex des aktiven Bereichs (3) ist und/oder der Brechungsindex des Substrats größer oder gleich dem Brechungsindex einer die Halbleiterschichtenfolge (2) auf der dem Substrat zugewandten Seite abschließenden Halbleiterschicht ist.

5. Halbleiterchip nach mindestens einem der vorhergehenden Ansprüche 2 bis 4,
bei dem das Substrat (4) strahlungsdurchlässig für die in dem aktiven Bereich (3) erzeugte Strahlung ist.

6. Halbleiterchip nach mindestens einem der vorhergehenden Ansprüche 2 bis 5,
bei dem eine Oberfläche des Substrats (4), insbesondere die Seitenfläche und/oder die der Halbleiterschichtenfolge zugewandte Oberfläche, als Strahlungsauskoppelfläche des Halbleiterchips (1) ausgebildet ist.

7. Halbleiterchip nach mindestens einem der vorhergehenden Ansprüche 2 bis 6,
bei dem sich die Ausnehmung (21) von der der Halbleiterschichtenfolge (2) abgewandten Oberfläche des Substrats (4) in Richtung der Halbleiterschichtenfolge erstreckt.

8. Halbleiterchip nach mindestens einem der vorhergehenden Ansprüche 2 bis 7,
bei dem die Ausnehmung (21) mittels des schräg zur Halbleiterschichtenfolge (3) verlaufenden Seitenflächenbereichs (18) und eines weiteren Seitenflächenbereichs (20) der Seitenfläche (17) gebildet ist, wobei der weitere Seitenflächenbereich im wesentlichen senkrecht zur Halbleiterschichtenfolge verläuft.

9. Halbleiterchip nach mindestens einem der vorhergehenden Ansprüche 2 bis 8,
bei dem sich das Substrat (4) mit wachsendem Abstand von der Halbleiterschichtenfolge (2) verjüngt.

10. Halbleiterchip nach mindestens einem der vorhergehenden Ansprüche 2 bis 9,
bei dem eine Oberfläche des Substrats (4), die der Kontaktschicht (5) zugewandte Oberfläche der Halbleiterschichtenfolge (2) und/oder die der Halbleiterschichtenfolge abgewandte Oberfläche der Kontaktschicht Erhebungen und Vertiefungen (20) aufweist.

11. Halbleiterchip nach mindestens einem der vorhergehenden Ansprüche 2 bis 10,
bei dem das Verhältnis des Flächeninhalts der der Halbleiterschichtenfolge zugewandten Oberfläche des Substrats (4) zu dem Flächeninhalt einer den Halbleiterchip lateral begrenzenden Seitenfläche (17) kleiner oder gleich zwei ist.

## Claims

1. An optoelectronic semiconductor chip (1) having a connection (6), an adhesion-promoting layer (9), a reflector layer (8) and a semiconductor layer sequence (2), which comprises an active region (3) suitable for generating radiation and has a lateral main extension direction, wherein
- the semiconductor layer sequence is arranged on a substrate (4) which has a side surface (17),
- the side surface has a side face region (18) which is inclined with respect to the main extension direction and / or a recess (21),
- the semiconductor chip has a radiation-transmissive and electrically conductive contact layer (5),
- a connection layer adjoining the contact layer (5) is arranged in the semiconductor layer sequence, which has a dopant concentration which is greater on the part of the contact layer (5) than on the part of the active region (3),
- the reflector layer (8) is arranged between the active region (3) and the connection (6), and
- the adhesion-promoting layer (9) is arranged between the reflector layer (8) and the contact layer (5), and increases the adhesion of the reflector layer to the contact layer.

2. The semiconductor chip as claimed in the preceding claim,
wherein the contact layer (5) contains a radiation-transmissive and electrically conductive oxide, in particular a metal oxide, for example an indium oxide, a tin oxide, an indium tin oxide or a zinc oxide.

3. The semiconductor chip as claimed in claim 2,
wherein the semiconductor layer sequence (2), in particular the active region (3), contains a nitride compound semiconductor material.

4. The semiconductor chip as claimed in at least one of the preceding claims 2 or 3,
wherein the refractive index of the substrate (4) is greater than or equal to the refractive index of the active region (3), and/or the refractive index of the substrate is greater than or equal to the refractive index of a semiconductor layer terminating the semiconductor layer sequence (2) on the side facing the substrate.

5. The semiconductor chip as claimed in at least one of the preceding claims 2 to 4,
wherein the substrate (4) is radiation-transmissive to the radiation generated in the active region (3).

6. The semiconductor chip as claimed in at least one of the preceding claims 2 to 5,
wherein a surface of the substrate (4), in particular the side surface and/or the surface facing the semiconductor layer sequence, is formed as a radiation coupling-out area of the semiconductor chip (1).

7. The semiconductor chip as claimed in at least one of the preceding claims 2 to 6,
wherein the cutout (21) extends from that surface of the substrate (4) which is remote from the semiconductor layer sequence (2) in the direction of the semiconductor layer sequence.

8. The semiconductor chip as claimed in at least one of the preceding claims 2 to 7,
wherein the cutout (21) is formed by means of the side surface region (18) running obliquely with respect to the semiconductor layer sequence (3) and by means of a further side surface region (20) of the side surface (17), wherein the further side surface region runs substantially perpendicular to the semiconductor layer sequence.

9. The semiconductor chip as claimed in at least one of the preceding claims 2 to 8,
wherein the substrate (4) tapers with increasing distance from the semiconductor layer sequence (2).

10. The semiconductor chip as claimed in at least one of the preceding claims 2 to 9,
wherein a surface of the substrate (4), the surface of the semiconductor layer sequence (2) which faces the contact layer (5), and/or the surface of the contact layer which is remote from the semiconductor layer sequence has elevations and depressions (20).

11. The semiconductor chip as claimed in at least one of the preceding claims 2 to 10,
wherein the ratio of the area content in that surface of the substrate (4) which faces the semiconductor layer sequence to the area content in a side surface (17) that laterally delimits the semiconductor chip is less than or equal to two.

## Revendications

1. Puce semi-conductrice optoélectronique (1) avec une borne de raccordement (6), une couche adhésive (9), une couche réfléchissante (8) et une succession de couches semi-conductrices (2), laquelle comporte une zone active apte à générer un rayonnement (3) et laquelle présente une direction principale d'entendue latérale,
dans lequel
- la succession de couches semi-conductrices est agencée sur un substrat (4) lequel présente une face latérale (17),
- la face latérale présente une zone de face latérale inclinée (18) par rapport à la direction principale d'entendue latérale et/ou un évidement (21),
- la puce semi-conductrice présente une couche de contact (5) perméable au rayonnement et électroconductrice,
- une couche de liaison adjacente à la couche de contact (5) est agencée dans la succession de couches semi-conductrices, laquelle présente une concentration en dopant qui est plus importante du côté de la couche de contact (5) que du côté de la zone active (3),
- la couche réfléchissante (8) est agencée entre la zone active (3) et la borne de raccordement (6), et en ce que
- la couche adhésive (9) est agencée entre la couche réfléchissante (8) et la couche de contact (5), et augmente l'adhérence de la couche réfléchissante sur la couche de contact.

2. Puce semi-conductrice selon la revendication précédente,
dans laquelle la couche de contact (5) contient un oxyde perméable au rayonnement et conducteur d'électricité, en particulier un oxyde de métal, par exemple un oxyde d'indium, un oxyde d'étain, un oxyde d'indium-étain ou un oxyde de zinc.

3. Puce semi-conductrice selon la revendication 2, dans laquelle la succession de couches semi-conductrices (2), en particulier la zone active (3), contient un matériau semiconducteur de liaison à nitrure.

4. Puce semi-conductrice selon au moins l'une quelconque des revendications précédentes 2 ou 3,
dans laquelle l'indice de réfraction du substrat (4) est supérieur ou égal à l'indice de réfraction de la zone active (3) et/ou l'indice de réfraction du substrat est supérieur ou égal à l'indice de réfraction d'une couche semi-conductrice délimitant la succession de couches semi-conductrices (2) du côté tourné vers le substrat.

5. Puce semi-conductrice selon au moins l'une quelconque des revendications précédentes 2 à 4,
dans laquelle le substrat (4) est perméable au rayonnement pour le rayonnement généré dans la zone active (3).

6. Puce semi-conductrice selon au moins l'une quelconque des revendications précédentes 2 à 5,
dans laquelle une surface du substrat (4), en particulier la face latérale et/ou la surface tournée vers la succession de couches semi-conductrices, est conçu comme surface de découplage du rayonnement de la puce semi-conductrice (1).

7. Puce semi-conductrice selon au moins l'une quelconque des revendications précédentes 2 à 6,
dans laquelle l'évidement (21) s'étend de la surface du substrat (4) opposée à la succession de couches semi-conductrices (2) dans le sens de la succession de couches semi-conductrices.

8. Puce semi-conductrice selon au moins l'une quelconque des revendications précédentes 2 à 7,
dans laquelle l'évidement (21) est formé au moyen de la zone de la face latérale (18) orientée obliquement par rapport à la succession de couches semi-conductrices (3) et d'une autre zone de face latérale (20) de la face latérale (17), l'autre zone de face latérale étant orientée pour l'essentiel perpendiculairement à la succession de couches semi-conductrices.

9. Puce semi-conductrice selon au moins l'une quelconque des revendications précédentes 2 à 8,
dans laquelle le substrat (4) se rétrécit au fur et à mesure que l'écart par rapport à la succession de couches semi-conductrices (2) s'agrandit.

10. Puce semi-conductrice selon au moins l'une quelconque des revendications précédentes 2 à 9,
dans laquelle une surface du substrat (4), la surface de la succession de couches semi-conductrices (2) tournée vers la couche de contact (5) et/ou la surface de la couche de contact opposée à la succession de couches semi-conductrices, présente des élévations et des approfondissement (20).

11. Puce semi-conductrice selon au moins l'une quelconque des revendications précédentes 2 à 10,
dans laquelle le rapport entre la superficie de la surface du substrat (4) tournée vers la succession de couches semi-conductrices (4) d'une part et la superficie d'une face latérale (17) qui délimite latéralement la puce semi-conductrice d'autre part est inférieur ou égal à deux.
